# FASCICULE DE BREVET EUROPEEN

(11) **EP 3 174 092 B1**
(45) Date de publication et mention de la délivrance du brevet: **05.09.2018**
(21) Numéro de dépôt: 16200244.8
(22) Date de dépôt: 23.11.2016
(51) Int. Cl.: H01L 21/8234, H01L 21/8238, H01L 21/3065, H01L 29/66, H01L 21/02, H01L 21/311, H01L 29/40, H01L 49/02

(54) **PROCÉDÉ DE FORMATION DES ESPACEURS D'UNE GRILLE D'UN TRANSISTOR**
VERFAHREN ZUR BILDUNG VON ABSTANDHALTERN EINES GATES EINES TRANSISTORS
METHOD FOR FORMING SPACERS OF A TRANSISTOR GATE

(30) Priorité: 26.11.2015 FR 1561442
(43) Date de publication de la demande: 31.05.2017
(73) Titulaire: COMMISSARIAT À L'ÉNERGIE ATOMIQUE ET AUX ÉNERGIES ALTERNATIVES, 75015 Paris (FR)
(72) Inventeur: POSSEME, Nicolas, 38360 Sassenage (FR); GARCIA-BARROS, Maxime, 94200 Ivry Sur Seine (FR)
(74) Mandataire: Hautier, Nicolas

(56) Documents cités:
- EP-A1- 2 750 170
- US-A1- 2007 232 006
- US-A1- 2014 273 292
- ROMUALD BLANC ET AL: "Patterning of silicon nitride for CMOS gate spacer technology. I. Mechanisms involved in the silicon consumption in CH3F/O2/He high density plasmas", JOURNAL OF VACUUM SCIENCE & TECHNOLOGY B: MICROELECTRONICS AND NANOMETER STRUCTURES, vol. 31, no. 5, 1 janvier 2013 (2013-01-01), page 051801, XP055171054, ISSN: 2166-2746, DOI: 10.1116/1.4816466

## Description

### DOMAINE TECHNIQUE DE L'INVENTION

La présente invention concerne en général les transistors à effet de champs (FET) utilisés par l'industrie de la microélectronique et plus particulièrement la réalisation des espaceurs de grille des transistors de type métal-oxyde-semiconducteur (MOSFET) majoritairement utilisés pour la production de toutes sortes de circuits intégrés.

### ÉTAT DE LA TECHNIQUE

La course incessante à la réduction des dimensions qui caractérise toute l'industrie de la microélectronique n'a pu se faire qu'avec l'apport d'innovations clés tout au long de décennies de développement depuis que les premiers circuits intégrés ont été produits industriellement dans les années soixante. Une innovation très importante qui remonte aux années soixante-dix, et qui est toujours utilisée, consiste à réaliser les transistors MOSFET à l'aide d'une technique dans laquelle les électrodes de source et de drain sont auto alignés sur celles de grille et ne nécessitent donc pas d'opération de photogravure pour leur définition. Combiné avec l'utilisation de grilles en silicium polycristallin, ce sont les grilles elles-mêmes, réalisées en premier, qui servent de masque lors du dopage des zones de source et drain des transistors.

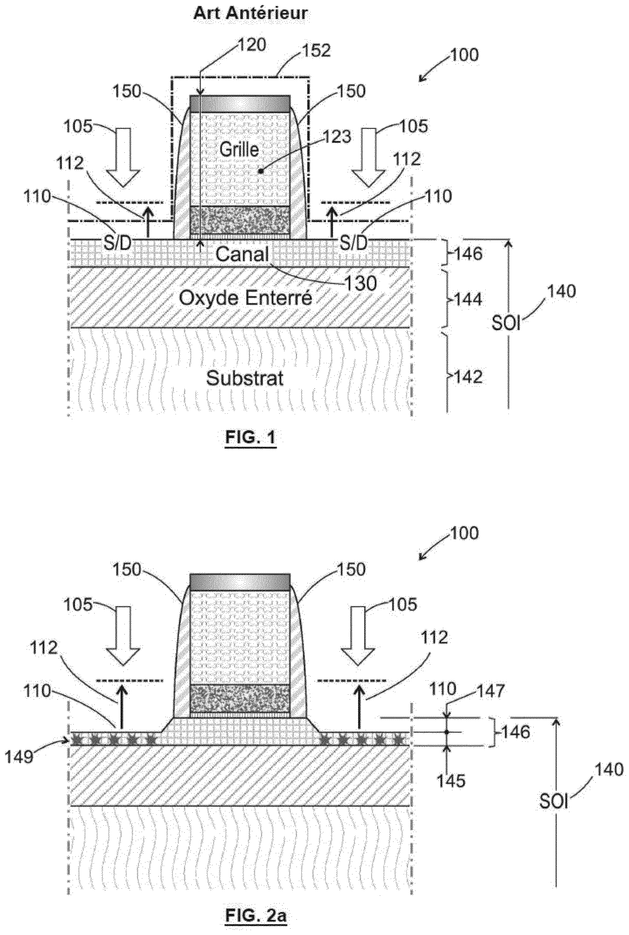

La **figure 1** est une vue en coupe d'un exemple de ce type de transistor 100 en cours de réalisation. On y retrouve les zones de source et de drain 110, globalement désignées zones source/drain, puisqu'elles sont très généralement parfaitement symétriques et peuvent jouer les deux rôles en fonction des polarisations électriques qui sont appliquées au transistor. La grille est classiquement constituée d'un empilement de couches 120 dont une grande partie est toujours constituée de silicium polycristallin 123. La formation des zones de source et drain se fait typiquement par implantation ionique 105 de dopants dans les zones 110, la grille 120 servant de masque comme mentionné ci-dessus, empêchant ainsi le dopage de la zone du transistor MOSFET dans laquelle, en fonction des tensions appliquées sur la grille, va pouvoir se développer le canal 130 de conduction entre source et drain.

La technique de base, très brièvement décrite ci-dessus, bien connue de l'homme du métier ainsi que de nombreuses variantes, a été constamment perfectionnée dans le but d'améliorer les performances électriques des transistors tout en permettant d'accommoder les réductions de taille successives des transistors nécessitées par une intégration toujours croissante d'un plus grand nombre de composants dans un circuit intégré.

Une technique largement utilisée actuellement consiste à fabriquer les circuits intégrés en partant de substrats élaborés 140 de type silicium sur isolant, désignés par leur acronyme SOI, de l'anglais « silicon on insulator ». Le substrat élaboré SOI est caractérisé par la présence d'une fine couche superficielle de silicium monocristallin 146 reposant sur une couche continue d'oxyde de silicium 144, dit oxyde enterré ou encore BOX, acronyme de l'anglais « buried oxide layer ». La solidité et la rigidité mécanique de l'ensemble sont assurées par la couche 142 qui constitue le corps du substrat SOI, souvent qualifié du vocable anglais de « bulk » pour indiquer que le substrat de départ est très généralement fait de silicium massif. Cette structure offre de nombreux avantages pour la réalisation des transistors MOSFET. Notamment, elle permet une réduction drastique des capacités parasites en raison de la présence de la couche continue isolante 144. En ce qui concerne l'invention, on retiendra seulement que la couche superficielle de silicium monocristallin 146 peut être contrôlée précisément en épaisseur et en dopage. En particulier, il est avantageux pour les performances des transistors que le canal 130 puisse être complètement déserté de porteurs, c'est-à-dire « fully depleted » (FD), vocable anglais qui est généralement utilisé pour désigner cet état. Ceci est obtenu en réalisant les transistors à partir de substrats SOI dont la couche superficielle 146 est très mince ce qui n'est pas sans inconvénient par ailleurs comme on le verra dans la description de l'invention. Ce type de transistor est ainsi désigné par l'acronyme FDSOI.

Un perfectionnement de la technique de base d'auto alignement qui a été universellement adopté consiste en la formation d'espaceurs 150 sur les flancs de la grille. Les espaceurs 150, typiquement faits de nitrure de silicium (SiN), vont permettre en particulier la mise en oeuvre d'une technique dite de « Source et Drain surélevés ». Pour pouvoir maintenir de faibles résistances électriques d'accès aux électrodes de source et de drain, en dépit de la réduction de taille des transistors, il a fallu en effet augmenter leur section. Ceci est obtenu par épitaxie sélective des zones source/drain 110. Au cours de cette opération on va faire croître 112 localement la couche initiale de silicium monocristallin 146. Il faut alors protéger les zones de grilles pour empêcher la croissance de se faire également à partir du silicium polycristallin 123 de la grille. C'est, entre autres, le rôle des espaceurs que d'assurer cette fonction. Ils assurent également un rôle de préservation de la grille lors de la siliciuration des contacts (non représentée) qui est ensuite effectuée dans le même but afin de diminuer la résistance série d'accès aux électrodes du transistor.

La formation des espaceurs 150 est devenue une étape cruciale de formation des transistors qui atteignent désormais des dimensions qui se mesurent couramment en nanomètres (nm = 10⁻⁹ mètres) et qui sont globalement de tailles décananométriques. La réalisation des espaceurs se fait sans faire intervenir aucune opération de photogravure. Ils sont auto alignés sur la grille 120 à partir du dépôt d'une couche uniforme de nitrure de silicium 152 (SiN) qui subit ensuite une gravure très fortement anisotrope. Cette gravure du SiN attaque préférentiellement les surfaces horizontales, c'est-à-dire toutes les surfaces qui sont parallèles au plan du substrat SOI. Elle ne laisse en place, imparfaitement, que les parties verticales de la couche 152, celles sensiblement perpendiculaires au plan du substrat, afin d'obtenir en pratique les motifs 150 dont la forme idéale serait évidemment rectangulaire. Un exemple de procédé de formation d'espaceurs d'une grille d'un transistor à effet de champ est divulgué dans la demande de brevet européen EP2750170-A1. Avec les solutions connues, la réduction de taille des transistors rend très délicate l'obtention d'espaceurs jouant pleinement leur rôle d'isolation et n'induisant pas de défauts dans la réalisation de transistors à partir de substrats SOI. En effet, dans le cadre de la présente invention, et comme cela sera détaillé par la suite, il a été constaté que plusieurs types de défaut tels que ceux mentionnés ci-dessous apparaissent lors de la gravure des espaceurs en utilisant l'un ou l'autre des procédés connus de gravure anisotrope.

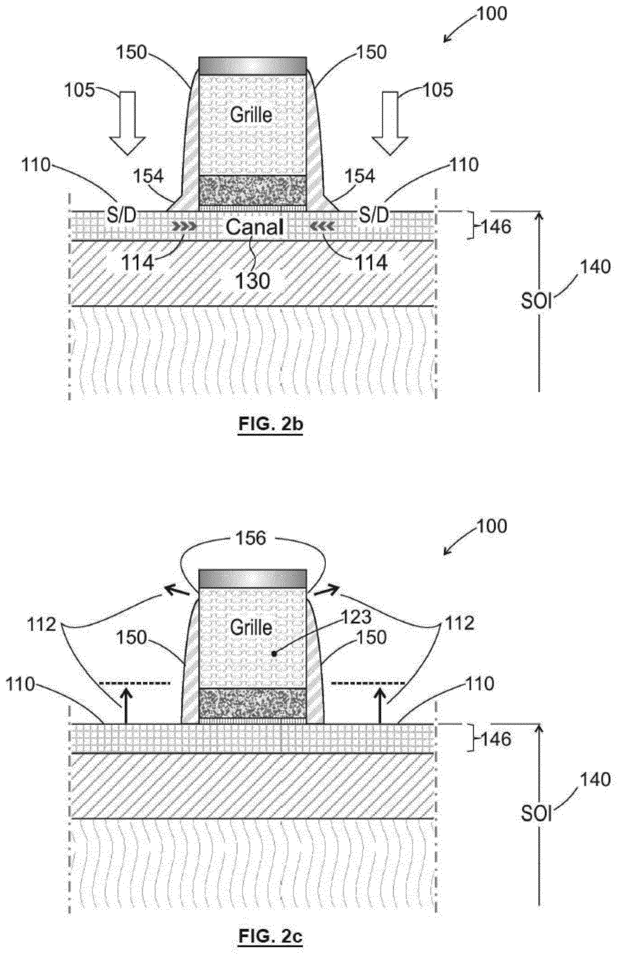

Les **figures 2a****,** **2b et 2c** illustrent chacune un type de défaut observé.

On utilise notamment un type de gravure qui est dite « sèche » et qui se met en oeuvre à l'aide d'un procédé qui est le plus souvent désigné par son acronyme RIE, de l'anglais « reactive-ion eching », c'est-à-dire : « gravure ionique réactive ». Il s'agit d'un procédé de gravure dans lequel on forme, dans une enceinte confinée, un plasma qui réagit physiquement et chimiquement avec la surface de la tranche à graver. Dans le cas de la gravure d'une couche de nitrure de silicium, qui est comme on l'a vu le matériau préféré pour la réalisation des espaceurs, le gaz réactif est typiquement le fluorure de méthyle (CH3F) que l'on fait réagir avec le matériau à graver en introduisant également du dioxygène (O2). On forme ainsi un plasma de gravure basé sur la chimie du fluor et souvent désigné par ses constituants : CH3F/O2/He. Dans ce plasma le composé fluor sert à graver le nitrure de silicium tandis que l'oxygène permet de limiter la polymérisation du fluorure de méthyle et sert également à oxyder le silicium lorsque ce matériau est atteint en cours de gravure. La couche d'oxyde formée sur le silicium permet de ralentir la gravure du silicium au prix cependant d'une transformation en surface de ce dernier en oxyde et donc d'une consommation superficielle de silicium. L'hélium sert de diluant pour l'oxygène.

L'avantage de ce type de gravure est qu'elle est assez anisotrope et permet de contrôler suffisamment le profil des espaceurs 150 même si l'on ne peut pas obtenir en pratique la forme rectangulaire idéale. L'inconvénient de ce type de gravure est que la sélectivité d'attaque du silicium sous-jacent est cependant limitée. La sélectivité, c'est-à-dire le rapport des vitesses de gravure entre le nitrure de silicium et le silicium est de l'ordre de 10 et peut atteindre 15 au maximum en fonction des conditions de formation du plasma (le nitrure est gravé 10 à 15 fois plus vite que le silicium).

On utilise aussi des gravures dites « humides » à base d'acide fluorhydrique (HF) ou d'acide phosphorique (H3PO4), ce dernier en particulier pour le SiN, qui ont une bien meilleure sélectivité, respectivement, vis-à-vis du silicium ou de son oxyde (SiO2) mais qui ne permettent pas cependant de contrôler le profil des espaceurs puisque la gravure est essentiellement isotrope dans ce cas. On notera ici que ce type de gravure est aussi qualifié de « nettoyage humide » traduction de l'anglais « wet clean ».

On notera ici qu'il existe de nombreuses publications sur le sujet de la gravure du nitrure de silicium et/ou des espaceurs de grille en général. On pourra se référer par exemple aux brevets ou demandes de brevets américains suivants : 2003/0207585 ; 4 529 476 ; 5 786 276 et 7 288 482.

La **figure 2a** illustre un premier problème qui est en relation avec la sélectivité insuffisante d'attaque qui existe lors d'une gravure sèche de type CH3F/O2/He entre le nitrure de silicium et le silicium de la couche superficielle 146. Le résultat est qu'une fraction significative de la mince couche superficielle de silicium monocristallin 146 du substrat SOI peut être alors partiellement consommée 147 lors de la gravure anisotrope du nitrure. Comme précédemment mentionné, la couche superficielle 146 est choisie pour être de faible épaisseur afin d'améliorer les caractéristiques électriques des transistors. Elle est typiquement inférieure à 10 nm. L'épaisseur restante 145 peut être très faible. Dans ces conditions l'implantation ionique 105 pour former les zones de source et de drain 110 qui va suivre est susceptible d'être très dommageable pour le silicium monocristallin restant. L'énergie d'implantation des dopants peut être suffisante pour provoquer une amorphisation complète 149 du silicium monocristallin ce qui va alors notamment compromettre l'étape de croissance épitaxiale 112 suivante destinée à former les source/drain surélevés. Comme précédemment mentionné, cette dernière opération est rendue nécessaire en raison de la diminution de taille des transistors afin de pouvoir maintenir les résistances d'accès aux électrodes de source et de drain à des valeurs suffisamment faibles pour ne pas impacter le fonctionnement électrique des transistors. Une croissance à partir d'une couche de silicium partiellement ou totalement rendue amorphe va créer de nombreux défauts dans la couche formée par épitaxie.

La **figure 2b** illustre un autre problème où il n'y a pas consommation significative du silicium de la couche superficielle 146 mais il y a formation de « pieds » 154 au bas des motifs de nitrure de silicium restants sur les flancs de la grille après gravure. La conséquence est que la transition 114 des jonctions qui sont formées après dopage par implantation ionique 105 des zones de source et drain 110, avec la zone du canal 130, est beaucoup moins abrupte que lorsque les espaceurs n'ont pas de pieds comme représenté dans les figures précédentes. La présence de pieds 154 affecte les caractéristiques électriques des transistors. On remarquera ici que la formation ou non de pieds au bas des espaceurs et la consommation ou non de silicium de la couche superficiel de silicium 146 du substrat SOI, décrite dans la figure précédente, sont des paramètres de réglage antagonistes de la gravure qui nécessitent qu'un compromis puisse être trouvé pour lequel, idéalement, on ne forme pas de pieds et on n'attaque pas significativement la couche superficielle de silicium.

La **figure 2c** illustre un troisième problème qui se produit quand la gravure produit une érosion trop importante des espaceurs dans les parties hautes des grilles et met à nu le silicium polycristallin 123 dans ces zones 156. La conséquence est que la croissance épitaxiale 112 ultérieure pour former les source/drain surélevés va aussi se produire à ces endroits, ainsi qu'une siliciuration de contacts parasites, ce qui risque de provoquer des courts circuits entre électrodes. En effet, la gravure des espaceurs demande que le temps de gravure soit ajusté pour graver, par exemple, 150% de l'épaisseur de nitrure déposé. C'est-à-dire que l'on pratique une surgravure de 50% dans cet exemple afin de tenir compte de la non uniformité du dépôt, ou de l'opération de gravure elle-même, au niveau d'une tranche. Ainsi, dans certaines parties de la tranche on pourra constater qu'il y a une surgravure trop prononcée qui met à nu les zones de grille 156. Ce type de défaut est aussi qualifié de « facettage ».

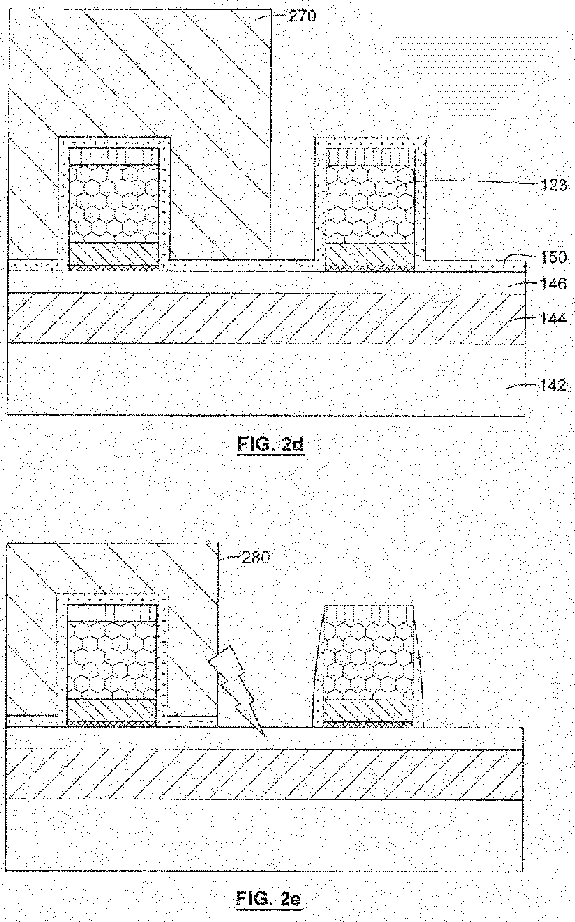

Un autre type de problèmes qui se pose lors des opérations de gravure des espaceurs est lié au fait que l'on doit réaliser comme sur un même circuit intégré des transistors à canal P et à canal N. Comme illustré sur les figures 2d et 2e, il faut alors protéger avec de la résine photosensible 270 tous les transistors de type N, pendant que l'on réalise ceux de type P et vice versa. Ceci ajoute une contrainte supplémentaire aux étapes de gravure ci-dessus, qui doivent laisser en place une épaisseur suffisante 280 de résine, pour les opérations suivantes de fabrication qui sont spécifiques à un type de transistor.

La présente invention a pour objet de proposer un procédé de formation d'espaceurs jouant pleinement leur rôle d'isolation et qui supprimerait ou limiterait au moins certains des défauts dans la réalisation de transistors, tels que la consommation ou l'altération du matériau semi-conducteur (i.e. Si, SiGe) de la couche active, la formation de « pieds » au bas des motifs sur les flancs de la grille d'un transistor, la consommation d'une couche de protection à base de carbone etc.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un aspect de la présente invention concerne un procédé de formation des espaceurs d'une grille d'un transistor à effet de champ, la grille étant située au-dessus d'une couche active en un matériau semi-conducteur, comprenant
- une étape de formation d'une couche de protection recouvrant la grille dudit transistor. Cette la couche de protection est de préférence une couche à base de nitrure (N) et/ou à base de silicium (Si) et/ou à base de carbone (C) qui présente une constante diélectrique égale ou inférieure à 8 ;
- une étape de dépôt d'une couche comprenant du carbone. Cette couche comprenant du carbone étant distante dudit transistor. Selon un mode de réalisation non limitatif elle forme un bloc de masquage qui encapsule une autre structure telle qu'un autre transistor ;
- au moins une étape de modification de la couche de protection, réalisée après l'étape de formation de la couche de protection, par mise en présence de la couche de protection avec un plasma comprenant des ions plus lourds que l'hydrogène et du CxHy où x est la proportion de carbone et y est la proportion d'hydrogène pour former une couche de protection modifiée et former un film carboné.

L'étape de modification est réalisée de manière à ce que le plasma provoque un bombardement anisotrope d'ions à base d'hydrogène provenant du CxHy selon une direction principale d'implantation parallèle à des flancs de la grille et de sorte à former une couche de protection modifiée en modifiant des portions de la couche de protection situées sur le sommet de la grille et de part et d'autre de la grille et de sorte à conserver des portions non modifiées, ou tout au moins non modifiées sur toute leur épaisseur, de la couche de protection recouvrant les flancs de la grille.

Les ions à base d'hydrogène sont de préférence pris parmi : H, H⁺, H₂⁺, H₃⁺.

Un film carboné est un film comprenant des espèces chimiques contenant du carbone. Selon un mode de réalisation non limitatif le film carboné est en carbone. Avantageusement, le film carboné peut contribuer à protéger les flancs de la grille lors du bombardement en évitant que de l'hydrogène ou des ions lourds ne viennent modifier la couche de protection ou ne viennent le modifier sur toute son épaisseur.

De manière très avantageuse, le film carboné contribue à protéger la couche de protection non modifiée au niveau des flancs lors de la gravure subséquente de la couche de protection modifiée par HF par exemple.

L'étape de modification est réalisée de manière à former un film carboné notamment sur des surfaces parallèles à la direction principale d'implantation également désignée direction du bombardement.
- au moins une étape de formation d'un film protecteur sur au moins la couche comprenant du carbone ainsi que sur la couche de protection modifiée et sur le film carboné recouvrant la grille. Il est de préférence mais optionnellement conforme.
   - une étape de retrait du film protecteur effectuée de manière à :
      ∘ retirer le film protecteur sur les surfaces du film protecteur qui sont perpendiculaires à la direction principale d'implantation, donc notamment sur le sommet de la grille et sur un sommet au moins de la couche comprenant du carbone ;
      ∘ conserver le film protecteur sur les surfaces du film protecteur qui sont parallèles à la direction principale d'implantation donc notamment sur les flancs de la grille;
   - une étape de retrait de la couche comprenant du carbone sélectivement à la couche de protection modifiée et au film protecteur. Ainsi lors du retrait de la couche comprenant du carbone, le film protecteur protège les flancs de grille. Cette étape de retrait de la couche comprenant du carbone n'endommage donc pas le film carboné et la couche de protection non modifiées qui sont présents sur les flancs de la grille.
   - au moins une étape de retrait de la couche de protection modifiée à l'aide d'une gravure sélective de la couche de protection modifiée vis-à-vis dudit film carboné et vis-à-vis des portions non-modifiées de la couche de protection.

Ainsi, le film carboné a été protégé par le film protecteur lors de l'étape de retrait de la couche comprenant du carbone formant par exemple un bloc de résine recouvrant une autre structure que ledit transistor. Ainsi, le film carboné est intègre lors de l'étape de retrait de la couche de protection modifiée. Lors de cette étape il peut ainsi jouer efficacement son rôle de couche de protection afin de protéger les portions non modifiées de la couche de protection destinée à former les espaceurs.

Ainsi, l'invention permet d'éviter que lors du retrait d'une partie au moins de la couche comprenant du carbone une partie du film protecteur soit consommé ce qui se traduirait par une perte de control dimensionnel lors du retrait de la couche de protection modifiée.

Par conséquent, l'invention propose une solution efficace pour résoudre la problématique consistant à améliorer le contrôle dimensionnel des espaceurs. L'invention est encore plus avantageuse dans un contexte dans lequel il faut effectuer une étape de retrait de la couche comprenant du carbone (par exemple une couche de résine) avant l'étape de formation des espaceurs par retrait de la couche de protection modifiée.

La présente invention propose ainsi un procédé de formation d'espaceurs jouant pleinement leur rôle d'isolation et qui supprimerait ou limiterait au moins certains des défauts dans la réalisation de transistors, tels que la consommation ou l'altération du matériau semi-conducteur (i.e. Si, SiGe) de la couche active, la formation de « pieds » au bas des motifs sur les flancs de la grille d'un transistor, la consommation d'une couche de protection à base de carbone etc.

De manière particulièrement avantageuse, il a été constaté que le bombardement d'ions plus lourds que l'hydrogène tels que l'He permet aux espèces chimiques du plasma contenant du carbone provenant du CxHy de former un film protecteur de carbone (film carboné) notamment sur des surfaces parallèles à la direction du bombardement et tout en empêchant par ailleurs à ces espèces chimiques contenant du carbone de former un film carboné sur les surfaces de la couche de protection qui sont perpendiculaires à la direction du bombardement.

Le bombardement d'ions plus lourds que l'hydrogène détruit en effet le film carboné qui aurait tendance à se déposer sur les surfaces perpendiculaires à la direction du bombardement.

Lors de l'étape de retrait de la couche de protection modifiée, cette gravure grave les surfaces de la couche de protection modifiée qui ne sont pas recouvertes du film carboné. Ainsi, il est possible de protéger une structure sur laquelle le film carboné se forme. En outre, il a été constaté que le bombardement ionique n'empêche pas la formation de ce film carboné lorsque lorsqu'on met en présence une couche comportant du carbone avec le plasma. Ce film carboné fait alors office de film de protection qui empêche la modification de la couche carbonée recouverte par le film. Par ailleurs, la gravure de l'étape de retrait de la couche de protection modifiée étant sélective de la couche de protection modifiée par rapport au carbone, le film carboné formé sur la couche carbonée protège cette dernière lors de l'étape de retrait de la couche de protection modifiée.

De manière particulièrement avantageuse, la modification de la couche de protection par bombardement d'ions hydrogène (H) conduit à implanter ces ions à base d'hydrogène dans les couches visées. Cette modification par implantation d'ions permet d'améliorer considérablement la sélectivité de la gravure de cette couche par rapport au matériau semi-conducteur, typiquement du silicium. Cette implantation fait également que l'épaisseur de couche de protection modifiée se grave plus rapidement que la couche de protection non modifiée.

La gravure de l'étape de retrait de la couche de protection modifiée consomme ainsi la couche de protection modifiée préférentiellement à la couche de matériau semi-conducteur et aux portions non modifiées de la couche de protection. Ainsi, le risque de consommation excessive de la couche superficielle de matériau semi-conducteur est réduit voir supprimé.

De préférence, la modification de la couche de protection conserve une épaisseur partielle ou complète de couche de protection non modifiée sur les flancs de la grille. Cette épaisseur est conservée, au moins en partie, lors de la gravure sélective. Elle définit alors des espaceurs de grille.

Par ailleurs, le film carboné contribue à protéger la couche de protection non modifiée au niveau des flancs lors de la gravure de la couche de protection modifiée.

L'invention permet ainsi d'obtenir des espaceurs tout en réduisant voire en éliminant les problèmes des solutions connues et mentionnés précédemment.

Par ailleurs, l'invention offre des avantages liés à l'implantation par plasma.

L'implantation réalisée à partir d'un plasma comprenant lesdits ions à base d'hydrogène a pour avantage de permettre une implantation de manière continue dans un volume s'étendant dès la surface de la couche implantée.

L'implantation par plasma permet à la fois une action physique (bombardement ionique) et à la fois une action chimique (dépôt du film carboné).

En outre l'utilisation d'un plasma permet une implantation à des profondeurs plus faibles que les profondeurs minimales que l'on peut obtenir avec des implanteurs. Ainsi, une implantation par plasma permet d'implanter efficacement et de manière relativement homogène ou tout au moins de manière continue des épaisseurs fines que l'on peut ensuite retirer par une gravure sélective. Cette continuité d'implantation depuis la face implantée permet d'améliorer l'homogénéité de la modification selon la profondeur, ce qui conduit à une vitesse de gravure constante dans le temps de la couche implantée. Par ailleurs, l'augmentation de la sélectivité conférée par l'implantation vis à vis des autres couches est effective dès le début de la gravure de la couche implantée. L'implantation par plasma permet ainsi un contrôle significativement amélioré de la précision de gravure.

L'implantation plasma permet typiquement d'implanter puis de retirer des épaisseurs s'étendant depuis la surface de la couche implantée et sur une profondeur allant de 0 nm à 100 nm. Les implanteurs classiques, permettent une implantation dans un volume compris entre 30 nm et plusieurs centaines de nanomètres. En revanche, les implanteurs classiques ne permettent pas d'implanter les espèces entre la surface de la couche à implanter et une profondeur de 30 nm. Dans le cadre du développement de la présente invention, il a été remarqué que les implanteurs ne permettent alors pas d'obtenir une vitesse de gravure suffisamment constante de la couche de protection modifiée et ce depuis la surface de cette dernière, conduisant ainsi à une moindre précision de gravure comparé à ce que permet l'invention.

L'utilisation d'un plasma pour modifier la couche à retirer est donc particulièrement avantageuse dans le cadre de l'invention qui vise à retirer une fine épaisseur de la couche de protection, typiquement comprise entre 1 et 10 nm et plus généralement entre 1 et 30 nm.

L'étape de modification réalisée à partir d'un plasma modifie la couche de protection de manière continue depuis la surface de la couche de protection et sur une épaisseur comprise entre 1 nm et 30 nm et de préférence entre 1 nm et 10 nm.

De manière également avantageuse, la modification de la couche de protection par implantation d'ions à base d'hydrogène permet également d'améliorer la sélectivité de cette couche de protection modifiée par rapport à l'oxyde du matériau semi-conducteur.

Ainsi, lors de l'étape de modification les conditions du plasma, en particulier la concentration en CxHy, l'énergie des ions et la direction principale d'implantation sont choisies de manière à ce que :
- le plasma crée un bombardement d'ions à base d'hydrogène (H) provenant de CxHy anisotrope selon une direction privilégiée parallèle à des flancs de la grille et de sorte à modifier des portions de la couche de protection en dehors des flancs de la grille et tout en conservant des portions non modifiées, ou tout au moins non modifiées sur toute leur épaisseur, de la couche de protection recouvrant les flancs de la grille,
- des espèces chimiques du plasma contenant du carbone provenant du CxHy forment un film carboné notamment sur des surfaces parallèles à la direction du bombardement ;
- le plasma crée un bombardement des ions plus lourds que l'hydrogène qui empêche aux espèces chimiques contenant du carbone provenant du CxHy de former un film carboné notamment sur les surfaces de la couche de protection qui sont perpendiculaires à la direction du bombardement.

L'invention offre un autre avantage significatif en ce qu'elle est adaptée à l'utilisation de matériaux à faible permittivité.

Dans l'industrie de la microélectronique, la réduction toujours plus grande des dimensions des transistors MOSFET pose un problème de capacité parasite lié aux espaceurs. Plus précisément ce problème a trait à l'augmentation relative des valeurs de capacités parasites qui affectent directement les performances électriques des transistors, notamment celles entre canal de conduction et les régions de source et de drain qui dépendent directement de l'épaisseur des espaceurs et de la permittivité relative dite « k » du matériau les constituant qui est traditionnellement, comme on l'a vu, du nitrure de silicium. En effet, quand on procède à une réduction de taille des transistors, la valeur de ces capacités parasites ne diminue pas d'un même facteur que celui appliqué au pas de répétition ou « pitch » des grilles des transistors qui conditionne l'augmentation de densité d'intégration obtenue.

L'invention s'adapte parfaitement à l'utilisation de matériaux présentant une permittivité k inférieure à celle du nitrure de silicium dont le k est proche de 7,5).

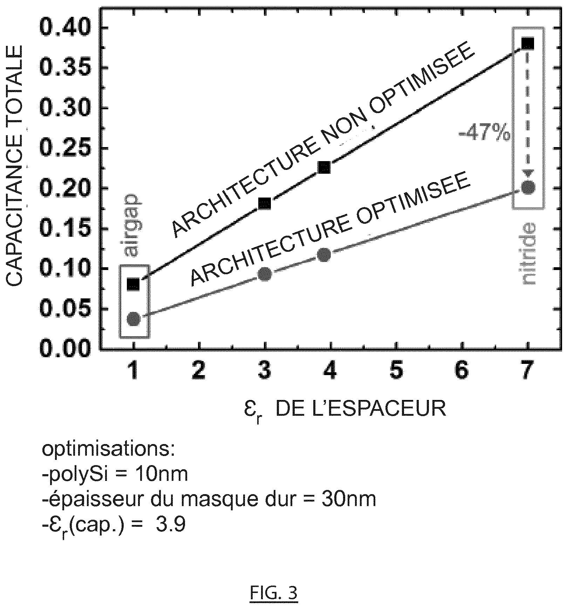

La **figure 3** illustre la dépendance de la capacité totale entre, d'une part, la grille et, d'autre part, les contacts de source et de drain, à la permittivité du matériau constituant les espaceurs. Pour réaliser les espaceurs on peut alors choisir des matériaux à faible permittivité dits à « faible k » tels que : l'oxycarbure de silicium (SiCO), le carbure de silicium (SiC), le carbonitrure de silicium (SiCN), et d'autres composés comme le SiOCN et le SiCBN dans une forme poreuse ou non.

De tels matériaux en couches minces réagissent d'une manière différente à la gravure sèche anisotrope que le nitrure de silicium (SiN) traditionnellement utilisé. Celle-ci se pratique conventionnellement dans un plasma de type CH₃F/He/O₂ qui peut modifier les propriétés diélectriques des films faits des matériaux mentionnés ci-dessus et a notamment pour effet d'augmenter leur permittivité relative ce qui va à l'encontre du but recherché. Au pire les modifications apportées au film par la gravure plasma peuvent faire que celui-ci deviennent très sensible aux opérations conventionnelles de nettoyage qui suivent, comme par exemple celle pratiquée avant épitaxie des zones de source et de drain dans une solution à base d'acide fluorhydrique (HF), jusqu'à complétement le faire disparaître.

Sont énoncées ci-après des caractéristiques optionnelles qui peuvent éventuellement être utilisées en association ou alternativement avec les caractéristiques ci-dessus:
Le bombardement d'ions plus lourds que l'hydrogène (désignés par la suite « ions lourds »), en particulier son énergie, sa direction et sa fluence sont prévues de sorte que le film carboné se forme sur les surfaces parallèles à la direction d'implantation et de sorte que le film carboné ne se forme pas sur les surfaces de la couche de protection qui sont perpendiculaires à la direction d'implantation. Plus précisément, le bombardement ionique consomme, de manière très anisotrope, les espèces chimiques contenant du carbone qui se déposent sur le fond des structures. Le bombardement suivant une direction perpendiculaire à la direction d'implantation (c'est-à-dire au niveau des flancs) est très faible. L'énergie des ions n'est donc pas suffisante pour empêcher la formation de ce film carboné.

Ladite couche comprenant du carbone est distante et distincte du transistor pour lequel on réalise les espaceurs. Cette couche comprenant du carbone forme par exemple un bloc de masquage d'une structure réalisée au préalable. Ainsi l'invention est particulièrement avantageuse pour réaliser des structures différentes sur un même substrat, par exemple un transistor NMOS adjacent à un transistor PMOS.

De préférence, la couche comprenant du carbone est une couche de résine photosensible ou thermosensible. Un transistor NMOS par exemple peut être recouvert d'une résine à base de carbone tandis qu'un transistor PMOS n'est pas recouvert par la résine. La résine protège le transistor NMOS lors de l'étape de modification et de gravure de la couche de protection du transistor PMOS.

Dans un autre mode de réalisation, cette couche comprenant du carbone est l'un parmi : une couche de polymère, du carbone amorphe, une couche anti réflective habituellement désignée par son acronyme BARC pour bottom anti-reflective coating, une couche à base de carbone déposée à la tournette (spin on carbon). Ladite couche comprenant du carbone peut également être l'une de ces couches associée à une couche de résine.

Il peut s'agir également de résine seule, ladite résine comprenant du carbone. Dans le cadre de la présente invention, on qualifie de résine un matériau pouvant être mis en forme par une exposition à un faisceau d'électrons, de photons ou de rayons X ou mécaniquement.

Dans un autre mode de réalisation, cette couche comprenant du carbone est un masque dur de préférence formé de carbone.

Dans un mode de réalisation avantageux, ladite couche comprenant du carbone est configurée pour recouvrir une structure distincte dudit transistor, ladite structure et le transistor étant sur un même substrat.

De préférence, ladite structure est située au-dessus de ladite couche active en un matériau semi-conducteur.

De préférence, ledit transistor est un transistor NMOS et ladite structure est un transistor PMOS. Dans un autre mode de réalisation préféré, ledit transistor est un transistor PMOS et ladite structure est un transistor NMOS.

Préférentiellement, lors de l'étape de modification réalisée par mise en présence de la couche de protection avec le plasma comprenant du CxHy, le film carboné recouvre les parois de la couche comprenant du carbone, l'épaisseur e2 du film carboné recouvrant les parois de la couche comprenant du carbone étant supérieure à l'épaisseur e1 du film carboné au niveau des flancs de la grille.

Ainsi le film carboné d'épaisseur e2 résiste au bombardement des ions, ce qui permet de protéger la couche comprenant du carbone lors de l'étape de modification.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1 illustre une vue en coupe d'un exemple de transistor MOSFET de type FDSOI en cours de réalisation.
Les FIGURES 2a à 2e illustrent différents défauts qui peuvent être observés sur des structures de transistors FDSOI lors de la gravure des espaceurs en utilisant l'un ou l'autre des procédés standard de gravure anisotrope développés par l'industrie de la microélectronique.
La FIGURE 3 illustre un autre problème lié à l'augmentation relative des capacités parasites associées aux espaceurs quand on réduit la taille des transistors.
Les FIGURES 4a à 4g illustrent les structures d'un transistor obtenues à l'issue des certaines des étapes du procédé selon un mode de réalisation de l'invention.
La FIGURE 5 montre l'épaisseur de la couche de protection obtenue en fonction des conditions du dépôt.
La FIGURE 6 résume les principales étapes d'un exemple de procédé de formation des espaceurs d'un transistor selon l'invention.
La FIGURE 7 illustre les étapes du retrait par voie sèche de la couche de protection modifiée.

Les dessins joints sont donnés à titre d'exemples et ne sont pas limitatifs de l'invention. Ces dessins sont des représentations schématiques et ne sont pas nécessairement à l'échelle de l'application pratique. En particulier, les épaisseurs relatives des couches et des substrats ne sont pas représentatives de la réalité.

### DESCRIPTION DÉTAILLÉE DE L'INVENTION

Il est précisé que dans le cadre de la présente invention, le terme « sur », « surmonte », « recouvrir » ou « sous-jacent » ou leurs équivalents ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans la description qui suit, les épaisseurs sont généralement mesurées selon des directions perpendiculaires au plan de la face inférieure de la couche à graver ou d'un substrat sur lequel la couche inférieure est disposée. Ainsi, les épaisseurs sont généralement prises selon une direction verticale sur les figures représentées. En revanche l'épaisseur d'une couche recouvrant un flanc d'un motif est prise selon une direction perpendiculaire à ce flanc.

De manière classique, la constante diélectrique d'une couche peut se mesurer par exemple selon la méthode dite de la goutte de mercure

Avant d'entamer une revue détaillée de modes de réalisation de l'invention, sont énoncées ci-après des caractéristiques optionnelles qui peuvent éventuellement être utilisées en association ou alternativement :
- la couche comprenant du carbone est configurée pour recouvrir une structure distincte dudit transistor.
- ledit transistor est un transistor NMOS et ladite structure est un transistor PMOS. Alternativement ledit transistor est un transistor PMOS et ladite structure est un transistor NMOS.
- l'étape de modification de la couche de protection et l'étape de formation du film protecteur sont effectuées dans un même réacteur plasma.
- l'étape de retrait du film protecteur comprend une gravure effectuée de manière à retirer le film protecteur sur le sommet de la grille et sur au moins un sommet de la couche comprenant du carbone et de manière à conserver le film protecteur sur les flancs de la grille.
- l'étape de retrait du film protecteur comprend une gravure plasma effectuée dans un même réacteur que ladite étape de modification.
- le film protecteur situé sur les flancs de la grille est retiré lors de l'étape de retrait de la couche de protection modifiée.
- le film protecteur est pris parmi : un oxyde et un nitrure.
- la couche de protection présente une constante diélectrique inférieure à 6 et de préférence à 4 et de préférence inférieure à 3.1 et de préférence inférieure ou égale à 2.
- la couche de protection est une couche à base de nitrure (N) et de préférence une couche de nitrure de silicium (SiN).
- la couche de protection est une couche à base de silicium (Si).
- la couche de protection est une couche à base de carbone (C).
- le matériau de la couche de protection est pris parmi : le SiCO, le SiC, le SiCN, le SiOCN, le SiCBN, le SiOCH, le CBN, le BN, et le SiO2.
- la couche de protection est une couche poreuse.
- la couche de protection est une couche non-poreuse.
- l'étape de formation de la couche de protection comprend une étape de dépôt de la couche de protection au cours de laquelle on effectue une étape de réduction de la constante diélectrique de la couche de protection.
- la constante diélectrique de la couche de protection comprend l'introduction d'une porosité dans la couche de protection.
- l'étape de formation de la couche de protection comprend l'introduction de précurseurs dans la couche de protection en cours de dépôt.
- l'étape de formation de la couche de protection comprend une étape de dépôt de la couche de protection au cours de laquelle on effectue une étape de réduction de la constante diélectrique de la couche de protection. L'étape de formation de la couche de protection comprend l'introduction de précurseurs dans la couche de protection en cours de dépôt. La couche de protection est une couche à base de nitrure de silicium. Les précurseurs sont choisis de manière à former des liaisons moins polaires que le nitrure de silicium, telles que le Si-F, le SiOF, le Si-O, le C-C, le C-H, et le Si-CH3.
- lors de ladite étape de modification de la couche de protection, la concentration en CxHy dans le plasma est comprise entre 2% et 50% et de préférence entre 4% et 40%.
- lors de ladite étape de modification de la couche de protection, la concentration en ions plus lourds que l'hydrogène dans le plasma est comprise entre 50% et 98%.
- le CxHy est du CH4.
- les ions plus lourds que l'hydrogène sont pris parmi l'argon (Ar), l'hélium (He), l'azote (N2), le xénon (Xe) et l'oxygène (O2).
- l'étape de modification est réalisée de manière à ce que le plasma génère un bombardement des ions plus lourds que l'hydrogène de manière anisotrope selon la direction principale d'implantation parallèle aux flancs de la grille de sorte à empêcher audites espèces chimiques du plasma contenant du carbone provenant du CxHy de former un film carboné sur les surfaces perpendiculaires aux flancs de la grille.
- l'étape de modification est réalisée de manière à ce que les ions plus lourds que l'hydrogène du plasma dissocient la molécule du CxHy de sorte à permettre aux ions hydrogène (H) provenant du CxHy de former des ions à base d'hydrogène et de s'implanter dans lesdites portions de la couche de protection.
- l'étape de modification est réalisée de manière à modifier uniquement une portion supérieure de l'épaisseur de la couche de protection au niveau des flancs de la grille en conservant une épaisseur non modifiée de la couche de protection au niveau des flancs de la grille.
- l'étape de retrait de la couche de protection modifiée est effectuée par gravure sélectivement à la couche active.
- lors de l'étape de modification les conditions du plasma, en particulier la concentration en CxHy, l'énergie des ions et la direction principale d'implantation sont choisies de manière à ce que, au niveau des surfaces perpendiculaires à la direction principale d'implantation, toute l'épaisseur de la couche de protection soit modifiée par l'implantation des ions à base d'hydrogène. L'étape de retrait de la couche de protection modifiée est réalisée de manière à retirer toute la couche de protection modifiée, mettant ainsi à nu la couche active au niveau des surfaces perpendiculaires à la direction principale d'implantation.
- l'étape de retrait de la couche de protection modifiée est effectuée par gravure humide.
- le matériau semi-conducteur est du silicium et l'étape de retrait de la couche de protection modifiée est effectuée par gravure humide sélectivement audit matériau semi-conducteur de la couche active et/ou à de l'oxyde de silicium (SiO2) formant le film protecteur de grille.
- la gravure sélective au silicium est obtenue à l'aide d'une solution à base d'acide fluorhydrique (HF).
- la couche de protection modifiée est à base de nitrure et la gravure sélective au silicium est obtenue à l'aide d'une solution à base de H3PO4.
- l'étape de retrait est effectuée par gravure sèche sélective de ladite couche de protection modifiée vis-à-vis dudit film carboné, vis-à-vis des portions non-modifiées de la couche de protection et vis-à-vis dudit matériau semi-conducteur.
- la gravure sèche est effectuée dans un plasma formé dans une enceinte confinée à partir de trifluorure d'azote (NF3) et d'ammoniac (NH3).
- la gravure sèche comprend : une étape de gravure consistant en la formation de sels solides ; une étape de sublimation des espèces solides.
- le procédé comprend plusieurs séquences comprenant chacune une étape de modification et une étape de retrait de la couche de protection modifiée. Au cours d'au moins l'une des étapes de modification, seule une partie de l'épaisseur de la couche de protection est modifiée.
- les séquences sont répétées de la couche de protection modifiée jusqu'à disparition de la couche de protection modifiée sur toutes les surfaces parallèles au plan d'un substrat sur lequel repose la grille.
- l'étape de modification de la couche de protection modifiée est une unique étape effectuée de manière à modifier la couche de protection dans toute son épaisseur sur toutes les surfaces parallèles au plan d'un substrat sur lequel repose la grille et à ne pas modifier la couche de protection dans toute son épaisseur sur les surfaces perpendiculaires à ce plan.
- l'étape de modification est précédée d'une étape de gravure anisotrope qui est effectuée dans un plasma de type CH3F/O2/He.
- le matériau semi-conducteur est pris parmi: le silicium (Si), le germanium (Ge), le silicium-germanium (SiGe).
- l'étape de modification réalisée à partir d'un plasma modifie la couche de protection de manière continue depuis la surface de la couche de protection et sur une épaisseur comprise entre 1 nm et 30 nm et de préférence entre 1 nm et 10 nm.

Des modes de réalisation détaillés de l'invention vont maintenant être décrits en référence aux figures.

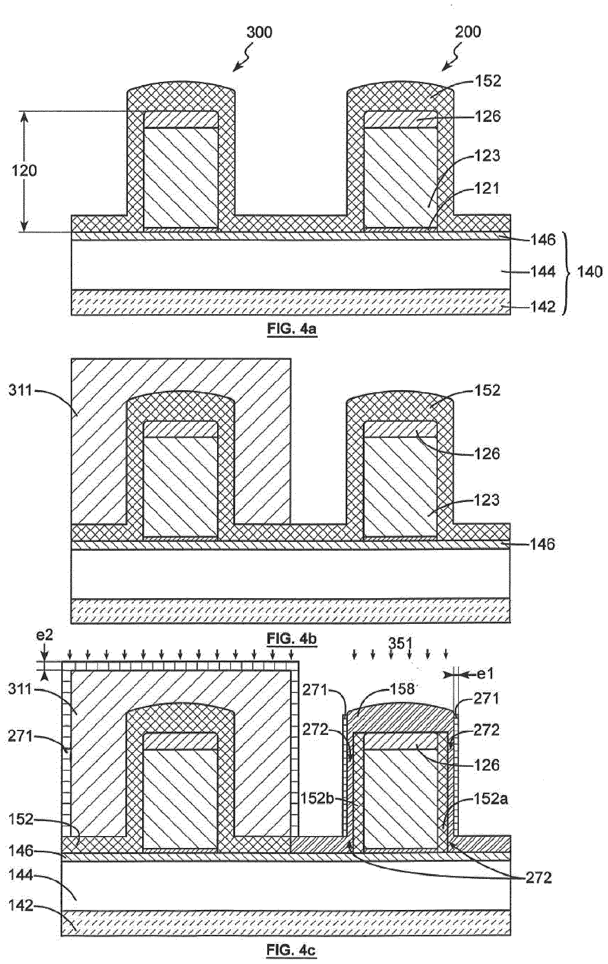

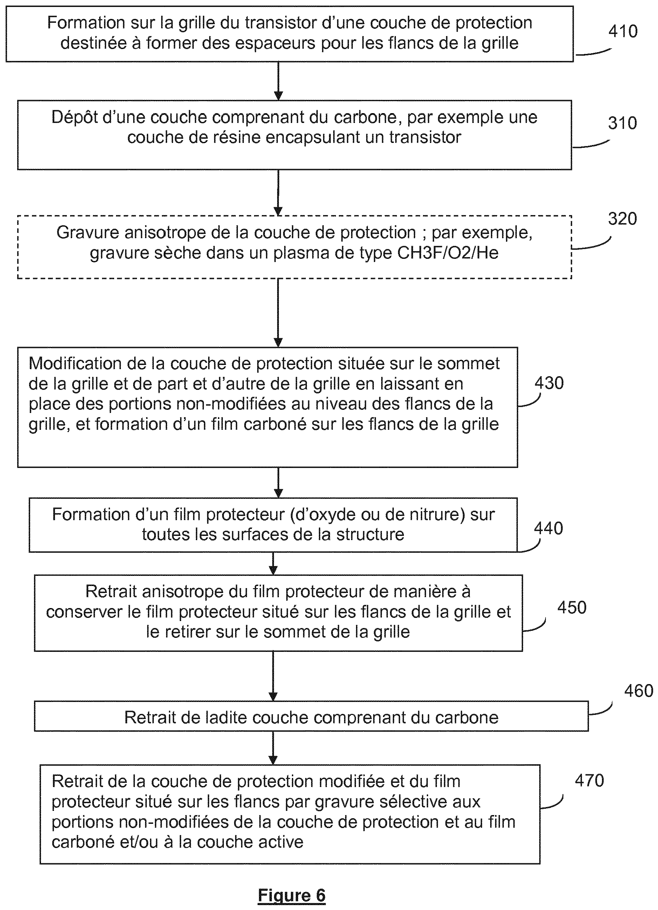

Les principales étapes 410 à 470 d'un exemple détaillé d'un procédé de formation des espaceurs d'un transistor selon l'invention sont illustrées en figure 4a à 4g. La **figure 6** résume ces étapes.

La **figure 4a** illustre une structure obtenue à l'issue de l'étape de formation 410 d'une couche de protection 152 recouvrant des transistors 200, 300 formés sur un substrat 140 de type SOI comprennent une couche active 146 surmontée d'une grille 120 du transistor 200.

La formation du transistor 200 ou 300 consiste notamment à réaliser un substrat élaboré 140 de type SOI, à partir d'un substrat 142, souvent désigné substrat massif (bulk substrat en anglais), une couche isolante initiale 144 et la couche active 146, cette dernière étant destinée à former ultérieurement un canal de conduction du transistor.

Alternativement, le matériau semi-conducteur est pris parmi: le germanium (Ge), le silicium germanium (SiGe).

En plus d'une couche de silicium polycristallin 123 on retrouve dans un empilement des couches formant la grille 120 tout d'abord une mince couche isolante d'oxyde de grille 121 à travers laquelle un champ électrique va pouvoir se développer pour créer un canal de conduction sous-jacent entre source et drain quand une tension électrique suffisante est appliquée sur la grille 120.

Dans les transistors MOSFET les plus récents il est mis en oeuvre une technologie qualifiée du vocable anglais de « high-k/metal gate » c'est-à-dire que la couche diélectrique 121 est faite d'un matériau isolant à haute permittivité (high-k) couverte par une couche métallique (metal gate ; non illustrée en figures) de la grille 120. À ce stade, l'empilement de couches de la grille 120 comprend aussi un masque dur 126 de protection qui sera enlevé ultérieurement pour permettre la reprise de contact sur cette électrode. Ce masque dur 126, qui reste en place après gravure de la grille, est typiquement fait d'oxyde de silicium (SiO2). Son rôle est de protéger le sommet de la grille 120 de tout dommage lors de la réalisation des étapes suivantes et notamment celles de gravure des espaceurs.

De préférence, la couche diélectrique 121 est disposée au contact de la couche active 146 formant le canal de conduction. De préférence, la couche métallique est disposée au contact de la couche diélectrique 121. De préférence, la couche de silicium polycristallin 123 est disposée directement au contact de l'oxyde de grille formée par la couche diélectrique 121 si la couche métallique est absente ou est disposée directement au contact de la couche métallique.

De manière préférentielle une structure 300 distincte du transistor 200 est formée, préalablement à l'étape de formation 410 de la couche de protection 152, sur le substrat 140 sur lequel repose la grille 120.

Dans cet exemple, et sans que cela ne soit limitatif, le transistor 200 est un transistor NMOS et la structure 300 est un transistor PMOS. Dans un autre mode de réalisation, le transistor 200 est un transistor PMOS et la structure 300 est un transistor NMOS.

L'étape de formation 410 de la couche de protection 152, d'épaisseur préférentiellement sensiblement constante, est effectuée de manière à recouvrir le transistor 200 et la structure 300, c'est-à-dire sur toutes les surfaces, verticales et horizontales, des dispositifs en cours de fabrication. Il s'agit ainsi d'un dépôt que l'on peut qualifier de conforme. De manière préférentielle mais non limitative, la couche de protection 152 est disposée directement au contact des surfaces des structures en cours de fabrication.

Cette étape de formation 410, se fait de préférence mais non limitativement à l'aide d'une méthode de dépôt dite LPCVD, acronyme de l'anglais « low pressure chemical vapor déposition », c'est-à-dire « dépôt chimique en phase vapeur à faible pression ». Ce type de dépôt qui se pratique à pression atmosphérique permet en effet un dépôt uniforme sur toutes les surfaces quelle que soit leur orientation.

Cette couche de protection 152 peut être à base de nitrure (N) et/ou de silicium (Si) et/ou de carbone (C). Elle présente une constante diélectrique égale ou inférieure à 8.

La couche de protection 152 est par exemple une couche de nitrure de silicium (SiN) dont la constante diélectrique est égale à 8 et de préférence à 7.

De manière avantageuse et non limitative, la couche de protection 152 comprend un matériau présentant une faible constante diélectrique inférieure à 4 et de préférence inférieure à 3.1 et de préférence inférieure ou égale à 2. Par exemple, les matériaux tels que le SiCO, le SiC, le SiCN, le SiOCN, le SiCBN, le SiOCH, le c-BN, le nitrure de bore (BN) et le SiO2, sont qualifiés de matériaux « low-k », c'est-à-dire à faible constante de diélectrique. Le matériau de la couche de protection 152 pris parmi les matériaux « low-k » tels que ci-dessus permet ainsi de réduire la capacité parasite pour améliorer la performance du transistor.

L'invention n'est néanmoins pas limitée aux exemples de matériaux tels que ci-dessus. La couche de protection 152 peut être d'un autre matériau présentant une faible constante diélectrique inférieure ou égale à 8 et de préférence à 7.

Dans un mode de réalisation avantageux, la couche de protection 152 est une couche poreuse. Alternativement, la couche de protection 152 est une couche non-poreuse.

De préférence, le matériau de la couche de protection 152 est compatible avec un nettoyage par voie sèche ou humide réalisé à une étape suivante 470 pour enlever une couche de protection modifiée 158 (décrite ultérieurement).

L'épaisseur de la couche de protection 152 est de préférence suffisamment importante, pour que après la réalisation des étapes de modification 430 et de retrait 470, il reste des portions non-modifiées 152a, 152b de la couche de protection 152 au niveau des flancs de la grille 120.

Dans un mode de réalisation préféré, l'épaisseur de la couche de protection 152 est comprise entre 5 nm et 30 nm, de préférence entre 5 nm et 20 nm, de préférence d'environ 10 nm.

De manière préférentielle mais uniquement facultative, le procédé de l'invention comprend une étape facultative de réduction de la constante diélectrique de la couche de protection 152. Selon un mode de réalisation avantageux, la réduction de la constante diélectrique est obtenue lors de l'étape de dépôt de la couche de protection 152.

Selon un mode de réalisation, la réduction de la constante diélectrique comprend l'introduction dans la couche de protection 152 en formation de précurseurs qui forment des liaisons réduisant la polarisabilité de la couche 152. Ces précurseurs sont choisis de manière à générer des liaisons moins polaires que le nitrure de silicium, telles que le Si-F, le SiOF, le Si-O, le C-C, le C-H, et le Si-CH3.

Selon un autre mode de réalisation, alternatif ou combinable au précédent, la réduction de la constante diélectrique comprend l'introduction dans la couche de protection 152 en formation d'une porosité.

La **figure 4b** illustre l'empilement à l'issue d'une étape de dépôt 310 d'une couche 311 comprenant du carbone.

Cette couche 311 comprenant du carbone étant distincte dudit transistor 200. Dans un mode de réalisation préférentiel, cette couche 311 comprenant du carbone est configurée pour recouvrir, typiquement pour encapsuler, la structure 300 distincte dudit transistor 200, la structure 300 et ledit transistor 200 étant sur le même substrat 140. Cette couche 311 comprenant du carbone peut faire office de protection pour la structure qu'elle recouvre. Elle forme par exemple un bloc de masquage comme illustré en figure 4b.

De préférence, la couche 311 comprenant du carbone est une couche de résine photosensible ou thermosensible comprenant du carbone. Dans le cadre de la présente invention, on qualifie de résine un matériau pouvant être mis en forme par une exposition à un faisceau d'électrons, de photons ou de rayons X ou mécaniquement. Dans un autre mode de réalisation, la couche 311 comprenant du carbone est un masque dur comprenant du carbone et de préférence formé de carbone.

Dans un autre mode de réalisation, cette couche 311 comprenant du carbone est l'un parmi : une couche de polymère, du carbone amorphe, une couche anti réflective habituellement désignée par son acronyme BARC pour bottom anti-reflective coating, une couche à base de carbon déposée à la tournette (spin on carbon). Ladite couche comprenant du carbone peut également être l'une de ces couches associée à une couche de résine.

Il peut s'agir également de résine seule, ladite résine comprenant du carbone.

La **figure 4c** illustre l'empilement à l'issue de l'étape de modification 430 de la couche de protection 152 et de formation d'un film carboné 271.

L'étape de la modification 430 de la couche de protection 152 telle que formée à l'issue de l'étape 410, se fait par mise en présence de la couche de protection 152 avec un plasma comprenant des ions plus lourds que l'hydrogène et du CxHy où x est la proportion de carbone et y est la proportion d'hydrogène et d'ions plus lourds que l'hydrogène, afin de former une couche de protection modifiée 158 et un film carboné 271.

Ainsi, les espèces du plasma remplissent trois fonctions au moins. Ces trois fonctions seront expliquées en détail dans la description ci-dessous.
« a » dépôt d'une couche protectrice formée du film carboné 271, sur les flancs de la grille 120 et sur la couche 311 comprenant du carbone lorsqu'elle est présente ;
« b » empêcher la formation du film carboné 271 sur les surfaces perpendiculaires aux flancs de la grille 120 ;
« c » modification de la couche de protection 152 dans toute son épaisseur ou sur une épaisseur importante sur les surfaces perpendiculaires aux flancs de la grille 120 et modification de la couche de protection 152 dans une moindre épaisseur sur les flancs de la grille 120. De préférence, la couche de protection 152 située sur le sommet de la grille 120 et de part et d'autre de la grille 120 est entièrement modifiée alors que la couche de protection 152 située sur les flancs de la grille 120 est non modifiée ou modifiée sur plus une faible épaisseur.

Du CxHy est introduit dans le plasma, par exemple du méthane (CH4) afin de réaliser les fonctions « a » et « c ». Les espèces chimiques du plasma contenant du carbone provenant du CH4 ou plus généralement du CxHy assurent la fonction « a ». Pour remplir la fonction « b », le plasma comprend des ions plus lourds que l'hydrogène tels que l'hélium (He), l'argon (Ar), l'azote (N2), le xénon (Xe) et l'oxygène (O2). Par souci de concision, ces ions sont désignés dans la suite de la description « ions lourds ».

La fonction « c » est assurée par des ions à base d'hydrogène. Les ions à base d'hydrogène sont de préférence pris parmi : H, H⁺, H₂⁺, H₃⁺. Dans la suite de la description, et par souci de concision, on désignera les ions à base d'hydrogène « ions hydrogène ». Ces ions ont pour propriété de pénétrer facilement et en profondeur dans la couche de protection 152. Ils modifient ainsi la couche de protection 152 mais sans la pulvériser. Les ions lourds pénètrent beaucoup moins profondément dans la couche de protection 152. Ces ions lourds restent localisés en surface et ne sont donc pas aptes à modifier une épaisseur importante, et a fortiori toute l'épaisseur, de la couche de protection 152. La profondeur de pénétration des ions lourds est environs dix fois plus faible que la profondeur de pénétration des ions hydrogène.

Plus précisément, les ions à base d'hydrogène peuvent être implantés dans le matériau à graver, sans provoquer de dislocation de sa structure atomique telle qu'elle entraînerait une pulvérisation de ce dernier, et donc sans redépôt du matériau gravé sur les parois du réacteur ou les motifs en cours de gravure eux-mêmes, sont susceptibles de convenir.

Une fonction additionnelle est assurée par les ions lourds. Cette fonction additionnelle consiste à dissocier la molécule CxHy afin de libérer l'espèce H. L'hélium (He) est particulièrement efficace pour assurer cette fonction. Le mélange introduit dans le réacteur plasma comprend ainsi de préférence un mélange CxHy/He.

On notera ici que cette étape de modification 430 de la couche à graver peut se pratiquer de nombreuses façons différentes en adaptant toutes sortes de moyens couramment employés par l'industrie de la microélectronique. On utilise notamment des gravures standard dont lesquels on peut développer des plasmas à faible ou haute densité et où on peut contrôler l'énergie des ions pour permettre l'implantation des espèces légères ci-dessus destinées à modifier la couche à graver. On peut aussi utiliser un type de plasma dit par immersion couramment utilisé pour pratiquer une implantation d'espèces en surface d'un dispositif en cours de fabrication.

Une modification de la couche effectuée par une implantation à l'aide d'un plasma a pour avantage de permettre une implantation en continue depuis la surface libre de la couche de protection 152 et sur une épaisseur faible, typiquement comprise entre 0 et 100 nm voire entre 0 et 30 nm. Elle permet également de bénéficier d'une sélectivité améliorée dès le début de la gravure et d'une vitesse de gravure constante, conduisant à une précision de gravure améliorée.

L'emploi d'un plasma pour implanter la couche de protection 152 permet ainsi de retirer une couche très fine, typiquement comprise entre 1 et 10 nm et plus généralement entre 1 et 30 nm.

Cette étape de la modification 430 est réalisée pour que le plasma soit anisotrope de manière à bombarder les ions dans une direction 351 privilégiée parallèle aux flancs de la grille 120. Le plasma utilisé lors de cette étape 430 crée un bombardement d'ions à base d'hydrogène (H) provenant de la molécule du CxHy et s'implantant dans une portion supérieure de l'épaisseur de la couche de protection 152 au niveau des flancs de la grille 120. Ces ions à base d'hydrogène proviennent du CxHy dont la molécule est dissociée par les ions plus lourds que l'hydrogène du plasma.

Ainsi les ions modifient les surfaces perpendiculaires à la direction du bombardement sur une épaisseur plus importante que les surfaces parallèles à la direction du bombardement. Ainsi la portion supérieure de l'épaisseur de la couche de protection 152 au niveau des flancs de la grille 120 est modifiée sur une épaisseur moindre que la surface au sommet de la grille 120 et les surfaces de la couche de protection 152 recouvrant la couche active 146. Une épaisseur non modifiée 152a, 152b de la couche de protection 152 recouvrant les flancs de la grille 120 est conservée et deviendra des espaceurs 152a, 152b.

Ainsi les ions à base d'hydrogène pénètrent dans la couche de protection 152 pour la modifier. Dans le même temps, le CxHy, de préférence du CH4, du plasma tend à déposer un film carboné 271 sur les différentes parois.

Le bombardement d'ions plus lourds que l'hydrogène permet aux espèces carbonées provenant du CxHy de former le film carboné 271, notamment sur des surfaces parallèles à la direction du bombardement, tout en empêchant de former un film carboné 271 sur les surfaces de la couche de protection 152 qui sont perpendiculaires à la direction 351 du bombardement, tel que le fond des tranchées. En effet, les ions lourds du plasma pulvérisent les espèces carbonées provenant du CxHy qui aurait tendance à se former sur ces parois perpendiculaires à la direction d'implantation et empêchent donc la croissance de ce film carboné 271 sur ces parois perpendiculaires à la direction d'implantation.

En revanche, sur les surfaces qui reçoivent un bombardement moindre ou qui ne reçoivent pas de bombardement, ce film carboné 271 se forme. Ainsi, il se forme notamment sur les surfaces parallèles à la direction 351 du bombardement.

On notera que de manière particulièrement avantageuse, le film carboné 271 agit comme une couche de protection carbonée pour la couche de protection 152 qu'il recouvre, réduisant l'épaisseur sur laquelle les ions hydrogène pénètrent dans la couche de protection 152 et modifie cette dernière. Ainsi, le film carboné 271 permet d'augmenter la différence d'épaisseur de modification entre les surfaces recouvertes par le film carboné 271 et les surfaces qui ne le sont pas. On contrôle ainsi encore mieux l'épaisseur gravée.

Lors de ladite étape de modification de la couche à graver, la concentration en CxHy dans le plasma est de préférence, comprise entre 2% et 50% du débit total et de préférence entre 8% et 40%. Au-delà on sera en mode dépôt. La dilution dépendra du choix des espèces des ions lourds du plasma, He, N2, Ar ou O2 etc. Par exemple :
- pour He ou Ar il faut que le débit de CxHy soit inférieur à 4% du débit total ;
- pour N2 il faut que le débit de CxHy soit inférieur à 20% du débit total ;
- pour O2 il faut que le débit de CxHy soit inférieur à 50% du débit total.

Lors de ladite étape de modification de la couche à graver, la concentration en ions plus lourds que l'hydrogène dans le plasma est comprise entre 50% et 98% et de préférence entre 55% et 85% et de 60% et 80%. Ces concentrations se mesurent habituellement par un ratio entre les deux composants gazeux.

Dans la présente demande de brevet un ratio entre deux composants gazeux est un ratio portant sur les débits respectifs d'introduction des composants dans le réacteur plasma. Chaque débit se mesure habituellement en sccm. Typiquement un débit se mesure avec un débitmètre associé au réacteur.

Dans un mode de réalisation (tel qu'illustré précédemment) utilisant un plasma de He/CH4 de préférence sous forme de mélange, la couche de protection 152 est modifiée par les ions H venant du gaz de CH4. Les ions He détruisent ou empêchent la formation du film carboné 271 qui aurait tendance à se former sur les surfaces perpendiculaires à la direction 351 telles que les surfaces de la couche de protection modifiée 158 recouvrant la couche active 146 et le masque dur 126 au sommet de la grille 120.

Dans un autre mode de réalisation utilisant un plasma de H2/CH4/Ar, en plus des ions hydrogène, la nature des ions Argon et les paramètres du plasma, en particulier son énergie, permettent d'assurer une déplétion des groupements méthyles du film carboné 271 réalisée de manière anisotrope, de sorte que le film carboné 271 n'est pas formé sur les surfaces perpendiculaires à la direction 351 telles que ci-dessus.

Ainsi, l'argon permet d'empêcher, éventuellement à lui seul, également la formation du film carboné sur les surfaces perpendiculaires à la direction 351 de bombardement. Combiné à He, N2, Xe et/ou O2 il contribue à pulvériser le film carboné 271 qui aurait tendance à se former.

Ainsi, les ions lourds Ar, He, N2, Xe ou O2 permettent de renforcer l'action des ions à base d'hydrogène en empêchant également la formation du film carboné 271 sur les surfaces perpendiculaires à la direction principale 351 du bombardement.

On notera que dans tous ces modes de réalisation, les ions H du CH4 participent en synergie avec les ions lourds du plasma (He, Ar, N2, Xe ou O2 par exemple) à la modification de la portion 158 de la couche de protection 152, même si la profondeur de pénétration de ces ions lourds est plus faible que celle des ions à base d'hydrogène.

Ainsi, à l'issue de cette étape de modification 430, le film carboné 271 formé recouvre seulement les surfaces de la couche de protection 152 qui sont perpendiculaires ou fortement inclinées par rapport au plan du substrat 140, telles que les surfaces supérieures de la couche de protection modifiée 158 au niveau des flancs de la grille 120 et les parois ou flancs de la couche 311 comprenant du carbone.

On notera que de manière inattendue, le film carboné 271 se forme sur les parois de la couche 311 comprenant du carbone. Les ions du plasma ne pulvérisent pas le film carboné 271 formé sur les parois de la couche 311 comprenant du carbone. Il est probable que cela soit dû aux affinités chimiques et réactions moléculaires entre le carbone de la couche 311 et les espèces chimiques contenant du carbone provenant du CxHy. Cette affinité accélère l'obtention d'un régime de dépôt et favorise la formation du film carboné 271 sur la couche 311 comprenant du carbone. Le film carboné 271 se forme donc rapidement et en dépit du bombardement des ions lourds. Ce film carboné 271 agit ainsi comme une couche de protection pour la couche 311 comprenant du carbone et empêche cette dernière d'être dégradée par le bombardement ionique. Les dimensions de la couche 311 sont donc conservées malgré le bombardement ionique.

En raison des réactions moléculaires ci-dessus, l'épaisseur e2 du film carboné 271 recouvrant les parois de la couche 311 comprenant du carbone est supérieure à l'épaisseur e1 du film carboné 271 sur la couche de protection 152 (au niveau des flancs de la grille 120). De manière encore plus avantageuse, l'épaisseur e2 du film carboné 271 est au moins deux fois supérieure à l'épaisseur e1 du film carboné 271. Les épaisseurs e1 et e2 apparaissent sur la **figure 4c**.

Ainsi, le film carboné 271 agit comme une couche de protection pour la couche 311 comprenant du carbone, empêchant ou réduisant la modification de cette dernière sous l'effet du bombardement ionique.

On notera ici que l'étape de modification 430 peut se pratiquer de nombreuses façons différentes en adaptant toutes sortes de moyens couramment employés par l'industrie de la microélectronique, tel qu'à l'aide de tout type graveur, par exemple dans un réacteur ICP de l'anglais « Inductively Coupled Plasma » c'est-à-dire « plasma à couplage inductif », ou dans un réacteur de type CCP de l'anglais « Capacitive Coupled Plasma » c'est-à-dire « plasma à couplage capacitif » qui permet de contrôler l'énergie des ions. On peut aussi utiliser un type de plasma dit par immersion couramment utilisé pour pratiquer une implantation d'espèces en surface d'un dispositif en cours de fabrication.

Pour choisir les paramètres d'implantation l'homme du métier, afin de déterminer le comportement du matériau à graver dans le type d'implanteur choisi, procédera préalablement de préférence à des essais « pleine plaque » afin d'établir des courbes de comportement. Il en déduira les paramètres de l'implantation, en particulier l'énergie et la dose d'ions, c'est-à-dire le temps d'exposition, à utiliser pour atteindre l'épaisseur voulue de matériau à modifier.

A titre d'exemple, le tableau ci-après donne des conditions typiques de mise en oeuvre de l'étape de modification 430 de la couche de protection 152, réalisé par utilisation d'un plasma de He/CH4, de H2/CH4/Ar, de CH4/Ar, de CH4/N2, ou de CH4/N2/H2, en fonction du temps en secondes et la puissance de la polarisation (bias) en watts, etc. Ces conditions sont largement dépendantes de l'épaisseur à modifier de la couche de protection 152.

Dans l'exemple ci-dessous, la couche de protection 152 est une couche à base de nitrure telle qu'une couche de nitrure de silicium.

| | |
|---|---|
| Réacteur de gravure : | réacteur ICP ou CCP ou par immersion plasma de He/CH4 (He : 50 - 500 sccm, CH4 : **5 - 10** sccm), ou plasma de H2/CH4/Ar ou de H2/CH4/N2 (H2 : 50 - 500 sccm, CH4 : 5 - 15 sccm, Ar (Argon) ou N2 : 100 - 1000 sccm) |
| Épaisseur de la couche de protection 152 à modifier (épaisseur de la couche de protection modifiée 158) : | 1 - quelques dix nm, par exemple 6-10nm |
| Puissance de la source : | 0 - 2000 Watts |
| Puissance de polarisation (énergie des ions) : | 20 - 850V |
| Pression : | 5 milli Torr - 120 milli Torr |
| Température : | 10 - 100 °C |
| Temps : | quelques secondes à quelques centaines de secondes |

Un exemple plus précis de mise en oeuvre de l'étape de modification 430 permettant de modifier une épaisseur de 17 nm de nitrure, réalisé par utilisation d'un plasma de He/CH4, est décrit dans le tableau ci-dessous :

| | |
|---|---|
| Réacteur de gravure : | plasma de He/CH4 (He : 250 sccm, CH4 : **5 sccm**) |
| Épaisseur de la couche à base de nitrure 152 à modifier (épaisseur de la couche modifiée 158 à base de nitrure) : | 14 nm |
| Puissance de la source : | 500 W |
| Puissance de polarisation (énergie des ions) : | 250 V |
| Pression : | 10 milli Torr |
| Température : | 55°C-59°C |
| Temps : | 60 secondes |

Préférentiellement, la couche de protection 152 est modifiée sur toute son épaisseur au-dessus de la grille 120 et au-dessus de la couche active 146 et tout en laissant en place des portions non-modifiées 152a, 152b de la couche de protection 152 au niveau des flancs de la grille 120.

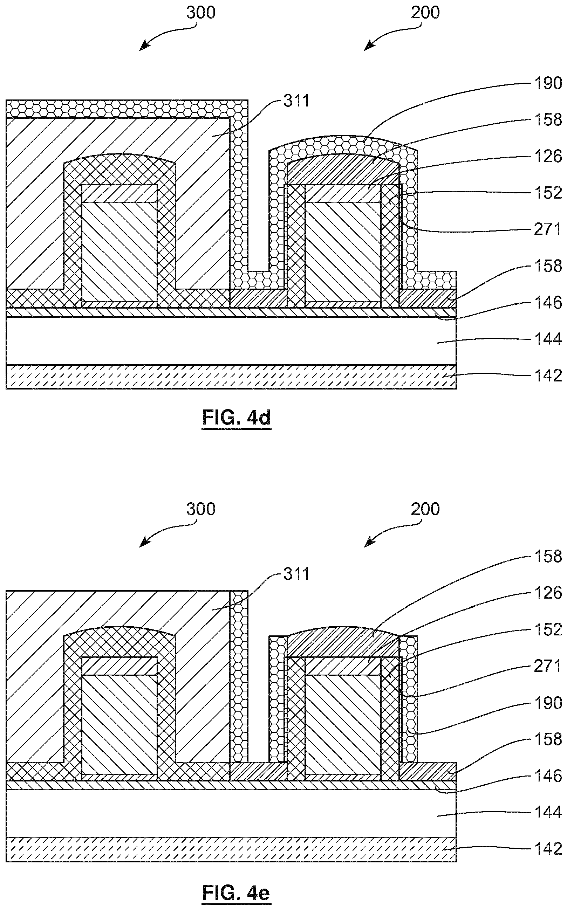

La **figure 4d** illustre le résultat d'une étape de formation 440 d'un film protecteur 190 sur toutes les surfaces de l'empilement.

Par exemple on procède au dépôt conforme d'un film protecteur 190 d'oxyde ou de nitrure sur l'ensemble de la structure, c'est-à-dire notamment sur :
- toutes les surfaces couvertes par la couche 152 qui ne sont pas protégées par la couche 311 comportant du carbone, typiquement la couche de résine incluant les zones qui ont été modifiées à l'étape précédente par implantation ionique et celles qui ne l'ont pas été en raison du caractère anisotrope de cette implantation ;
- Les flancs des espaceurs qui ont été recouverts du film carboné 271 ;
- toutes les surfaces couvertes par la couche 311 comportant du carbone.

La formation 440 de ce film protecteur 190 d'oxyde ou de nitrure est destinée à renforcer la protection des zones situées sur les flancs de la grille 120, zones qui vont constituer in fine les espaceurs. En particulier, le film protecteur 190 est destiné à empêcher que le film carboné 271 obtenu durant l'étape précédente de modification 430 par implantation ne soit enlevé lors de l'étape qui va suivre de retrait 460 du film protecteur 190.

Afin de ne pas rajouter d'étape supplémentaire dans une ligne de production le dépôt 440 du film protecteur 190 est préférentiellement effectué dans la même chambre que l'étape précédente de modification 430 par implantation. Toutefois, il est parfaitement envisageable que ces deux étapes 430, 440 se fassent dans deux chambres séparées.

On notera que la formation 440 du film protecteur 190 doit nécessairement se faire sur la résine 470 afin de pouvoir protéger les zones d'espaceurs situées les flancs des grilles. En effet dans le cas où le matériau ne se déposerait pas sur la couche 311 à base de carbone, il ne se déposerait pas non plus sur le film carboné 271.

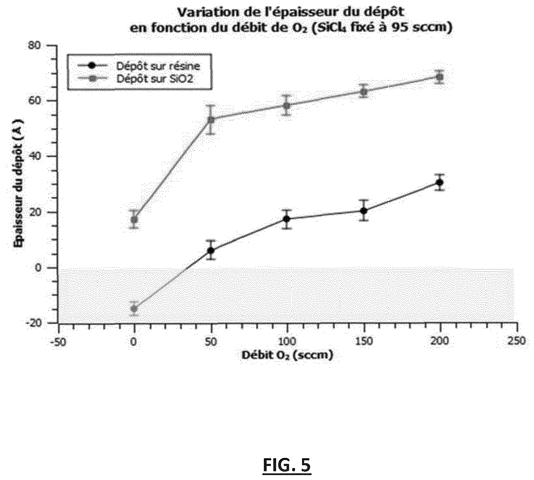

Pour ce faire, afin de former ce film protecteur 190 par dépôt, il est avantageux d'associer deux types de gaz : un gaz à base de silicium et un gaz diluant, par exemple du tétrachlorure de silicium (SiCl₄) et de l'oxygène (O₂). Comme illustré sur la **figure 5****,** on remarquera que les débits de gaz utilisés pour le dépôt doivent alors être supérieurs à un seuil pour pouvoir être effectivement dans un mode de dépôt sur la résine. Dans la figure 5 qui illustre un dépôt à partir de SiCl₄, avec un débit pour ce gaz fixé à 95 sccm (centimètre cube par minute) dans ce cas, le débit d'oxygène pour qu'il y ait effectivement croissance sur la résine doit alors être supérieur à un seuil 510 qui est dans cet exemple de 30 sccm.

De manière plus générale ce dépôt 440 du film protecteur 190 peut être effectué à partir d'un plasma formé à partir d'un gaz à base de silicium tel que le SiCl₄ mentionné ci-dessus ou le SiF₄ et d'un gaz tel que le 0₂ ou le N₂.

Il existe cependant une marge maximum à ne pas dépasser dans le dépôt 440 du film protecteur 190. Il faut pouvoir observer les motifs, c'est-à-dire les différentes structures telle que les transistors en cours de formation et leurs grilles en particulier. La hauteur du dépôt du film protecteur 190 est donc inférieure à la plus petite des deux longueurs suivante :
- la hauteur de la grille 123 additionnée de celle du masque dur 126.
- la demi-période entre transistors 200, 300 à laquelle sera retranchée la longueur d'une demi-grille et d'un espaceur.

La **figure 4e** illustre une étape 450 de retrait partiel du film protecteur 190 que l'on vient de déposer sur l'ensemble de la structure.

Cette étape de retrait 450 est effectuée de manière anisotrope afin de conserver le film protecteur 190 sur les flancs de la grille et à le supprimer notamment sur le sommet du bloc de masquage formé par la couche 311 comprenant du carbone ainsi que sur le sommet de la grille. De manière plus générale, ce retrait 450 est effectué dans une chambre de gravure, typiquement par plasma, selon une direction telle que les surfaces perpendiculaires aux flancs de la grille sont gravées et les surfaces parallèles aux flancs de la grille ne sont pas gravées.

Afin de ne pas rajouter d'étape supplémentaire dans une ligne de production le dépôt 440 du film protecteur 190 est préférentiellement effectué dans la même chambre que l'étape précédente. Toutefois, il est parfaitement envisageable que ces deux étapes 440 et 450 se fassent dans deux chambres séparées.

Les zones du film carboné qui demeurent après ce retrait offrent une seconde protection, en plus du film carboné 271, aux parties de la couche de protection 152 qui vont constituer in fine les espaceurs de grille des transistors.

Pour ce faire, on introduit dans la chambre ayant servi au dépôt de ce film 190 un gaz noble tel que l'hélium (He), l'argon (Ar) ou le xénon (Xe) qui ne réagit pas chimiquement avec le dépôt précédent et en appliquant une polarisation ou « bias » du plasma qui détermine la force du bombardement ionique permettant de retirer sélectivement ce qui a été former à l'étape précédente.

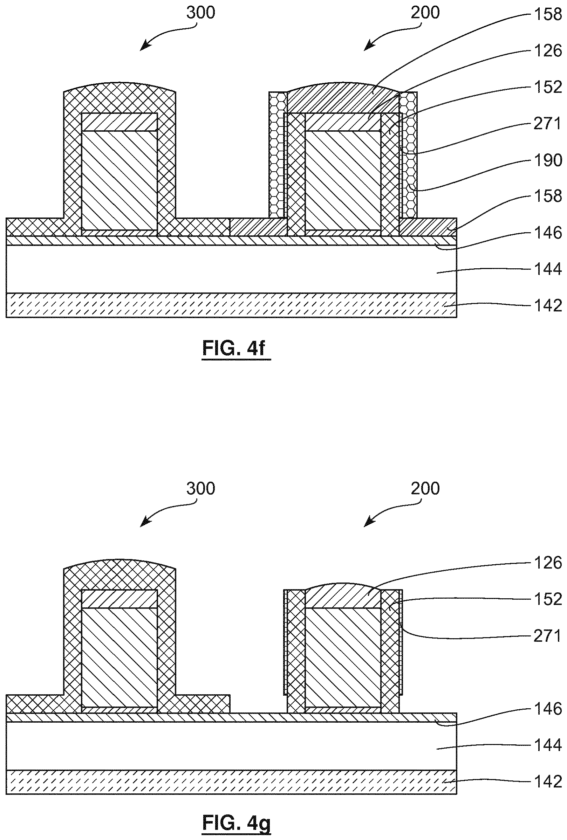

La **figure 4f** illustre une étape 460 de retrait de la couche 311 comportant du carbone et formant par exemple une couche de résine protégeant les transistors 300 de type opposé à celui 200 pour lequel on forme les espaceurs. Le choix de la chimie utilisée se fait en fonction du type de film protecteur 190 formé lors de l'étape 440. Si ce film 190 est formé par un dépôt d'oxyde, une chimie oxydante sera alors utilisée et dans le cas d'un dépôt nitruré une chimie réductrice sera utilisée. En fonction de l'épaisseur du film protecteur 190, ce dernier peut subsister entre les deux transistors 200, 300. En effet l'étape 460 de retrait de la couche 311 comportant du carbone n'attaque pas ce film 190. Naturellement si l'épaisseur de ce dernier est trop faible au regard de sa hauteur, ce film s'affaisse et est éliminé.

La **figure 4g** illustre le résultat de l'étape de retrait 470 de la couche de protection modifiée 158 après que l'on ait procédé à une opération de gravure sélective de la couche de protection modifiée 158 par rapport : au film carboné 271, aux portions non-modifiées 152a, 152b de la couche de protection 152 et à la couche active 146.

De préférence, cette étape 470 retire également les zones du film protecteur 190 conservées à l'issue de l'étape 460 sur les flancs de la grille.

La solution de gravure grave ainsi la couche de protection modifiée 158 à laquelle elle a directement accès sur le sommet de la grille 120 et dans le fond des tranchées.

Dans le cas où les ions à base d'hydrogène se sont implantés dans la couche de protection située sur les flancs de la grille, ce qui peut être le cas si le film carboné 271 est fin, une épaisseur de la couche de protection située sur les flancs de la grille est alors modifiée.

Lors de l'étape de retrait de la couche de protection modifiée, la solution de gravure peut s'introduire également dans l'espace situé au niveau des flancs de la grille 120, entre le film carboné 271 recouvrant les flancs et les portions non-modifiées 152a, 152b. Dans cet espace, occupé par la couche de protection modifiée 158 obtenue en fin d'étape de modification 430, la solution de gravure consomme la couche de protection modifiée 158. Les passages empruntés par la solution de gravure pour consommer cette portion de la couche de protection modifiée 158 sont référencés 272 sur la **figure 4c****.**

Dans ce cas, le film carboné 271 n'est plus soutenu et disparaît. Typiquement cette désagrégation du film carboné est qualifié de « lift off », soit de retrait par soulèvement.

Alternativement, dans le cas où les ions à base d'hydrogène ne se sont pas implantés dans la couche de protection située sur les flancs de la grille, ce qui peut être le cas si le film carboné 271 est suffisamment épais, la couche de protection située sur les flancs de la grille n'est pas modifiée ou que très peu modifiée. Lors de l'étape de retrait de la couche de protection modifiée, la solution de gravure ne retire donc pas la couche de protection 152 située sur les flancs. Le film carboné 271 reste donc maintenu par cette dernière. Il ne disparait alors pas lors de l'étape de retrait de la couche de protection modifiée. Ce mode de réalisation n'est pas illustré sur les figures.

Avantageusement, ces paramètres sont également réglés de manière à ce que la couche de protection modifiée 158 puisse être gravée sélectivement par rapport au matériau semi-conducteur de la couche active 146.

Dans un mode de réalisation dans lequel la couche de protection modifiée 158 est typiquement une couche à base de nitrure, l'étape de retrait 470 peut être effectuée par gravure humide en utilisant une solution de gravure à base d'acide fluorhydrique (HF) diluée par exemple à 1% ou d'acide phosphorique (H3PO4) pour le SiC, SiCN ou le SiN.

Pour éviter les problèmes des procédés conventionnels de gravure des espaceurs décrits dans les **figures 2a à 2c****,** il est nécessaire que la gravure de la couche de protection modifiée 158 soit la plus sélective possible par rapport au silicium notamment afin de ne pas attaquer le silicium de la couche active 146. Par exemple, dans ce mode de réalisation de gravure humide, il n'y a aucune consommation de silicium de la couche active 146 due à l'utilisation de la solution gravure à base d'acide fluorhydrique (HF).

Comme mentionné ci-dessus, l'épaisseur de la couche de protection modifiée 158 est typiquement comprise dans une gamme de valeurs allant de 1 nm à quelques dizaines de nm. Les temps de gravure peuvent aller de quelques secondes à quelques minutes en étant évidemment directement dépendants de l'épaisseur qui a été modifiée.

À titre d'exemple, pour enlever une épaisseur modifiée comprise entre 5 nm et 20 nm de nitrure modifié il faut de l'ordre de 30 secondes avec une solution d'acide fluorhydrique (HF) à 1%. Le même temps de gravure est obtenu avec de l'acide phosphorique dilué (H3PO4) à 85% pour graver une couche de nitrure de silicium (SiN) ou de SiC.

Une solution d'acide fluorhydrique (HF) peut être utilisée pour des couches de protection à base d'autres matériaux que le nitrure, le silicium et le carbone.

Par exemple, pour enlever une épaisseur modifiée de 15 nm de SiCBN modifié il faut de l'ordre de 30 secondes avec une solution d'acide fluorhydrique (HF) à 1%.

L'arrêt de ladite gravure sélective peut donc se faire sur les portions non-modifiées 152a, 152b de la couche de protection 152 ou/et sur le silicium monocristallin de la couche active 146 ou/et encore sur le masque dur 126 au sommet de la grille 120, jusqu'à la disparition de la couche de protection modifiée 158.

Pour le retrait de la couche de protection modifiée 158, on a de préférence recourt à une gravure humide qui combine le retrait de la couche de protection modifiée 158 avec un nettoyage humide de la tranche contenant les dispositifs en cours de fabrication, car après cette gravure humide, conventionnellement un nettoyage humide (traduction de l'anglais « wet clean ») est réalisé pour nettoyer un wafer sur lequel est le transistor 200.

De préférence, cette gravure humide est combinée avec le nettoyage humide, ce qui simplifie le procédé et apporte un gain de temps.

Les paramètres du nettoyage humide sont également réglés de manière à ce que la couche de protection modifiée 158 puisse être gravée très sélectivement par rapport aux espèces contenant du carbone du film carboné 271 notamment recouvrant des parois de la couche 311 comprenant le carbone, et aux portions non-modifiées (les espaceurs obtenus) 152a, 152b de la couche de protection 152.

Alternativement à une gravure humide, une gravure sèche de la couche de protection modifiée 158 sélectivement au silicium de la couche active 146, au matériau des espaceurs 152a, 152b, à l'oxyde de silicium (SiO2) du masque dur 126 pourra alors être aussi pratiquée pour cette étape de retrait 470 par voie sèche de la couche de protection modifiée 158.

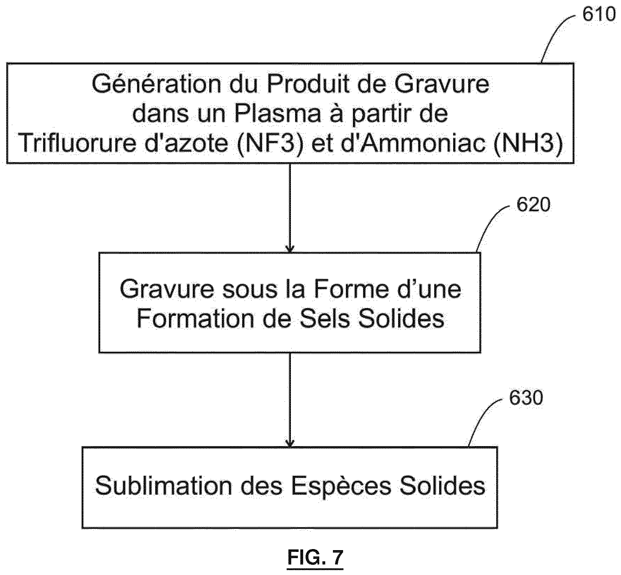

Le principe du retrait par voie sèche de la couche de protection modifiée 158 typiquement une couche modifiée 158 à base de nitrure comprend les étapes suivantes 610 à 630 illustrées en **figure 7** qui s'effectuent dans une chambre de réaction où l'on forme un plasma. Les épaisseurs traitées sont typiquement comprises entre 1 nm et quelques dizaines de nanomètres.

La méthode est celle décrite par H. Nishini et ses coauteurs dans une publication en anglais intitulée « Damage-free selective etching of Si native oxides using NH3/NF3 and SF6/H2O down flow etching » parue dans le « Journal of Applied Physics » volume 74 (2), en juillet 1993.

Le principe du retrait par voie sèche de la couche de protection modifiée 158 est proche de celui décrit dans la publication ci-dessus. La différence est que dans le cas de l'invention on ne grave pas de l'oxyde de silicium mais la couche de protection modifiée 158 par utilisation d'un plasma de type par exemple H2/CH4/Ar.

Le mécanisme est toutefois le même et comprend les étapes suivantes qui s'effectuent dans une chambre de réaction où l'on forme un plasma. Une première étape 610 consiste à générer le produit de gravure dans le plasma selon la réaction chimique suivante :

NF₃+NH₃ → NH₄F + NH₄F.HF

qui fait réagir du trifluorure d'azote (NF₃) avec de l'ammoniac (NH₃).

La gravure se fait au cours d'une deuxième étape 620, à une température de l'ordre de 30°C et plus généralement entre 10°C et 50°C, sous la forme d'une formation de sels selon la réaction chimique suivante :

NH₄F or NH₄F.HF + SiNH → (NH₄)2SiF₆ (solide) + H₂

Au cours d'une opération qui dure entre quelques secondes et quelques minutes et qui s'effectue sous une pression comprise entre quelques milli Torr et quelques Torr. Plus précisément, cette opération dure entre 20 secondes et 2 minutes et s'effectue sous une pression comprise entre 500 milli Torr et 3 Torrs.

Les espèces solides qui sont formées au cours de cette opération sont ensuite sublimées 630 à une température supérieure à 100°C pendant quelques dizaines de secondes selon la réaction suivante :

(NH₄)2SiF₆ (solid) → SiF₄(g) + NH₃(g) + HF(g)

Par exemple, pour enlever une couche de 10 nm de nitrure modifié 158 les flux de trifluorure d'azote (NF₃) et d'ammoniac (NH₃) sont respectivement de 50 sccm et de 300 sccm à 30°C pendant 45 secondes pour l'étape 620 de formation des sels qui est suivie par l'étape de sublimation 630 qui s'effectue à 180°C pendant 60 secondes.

Ce mode de réalisation permet d'obtenir une très bonne sélectivité de la gravure du couche de protection modifiée 158 par rapport aux portions non- modifiées 152a, 152b et au matériau semi-conducteur non modifié. En particulier, cette sélectivité de la gravure est très supérieure (typiquement un facteur 10 au moins) à celle obtenue avec une solution de HF.

À l'issue de l'étape de retrait 470, il ne reste donc que les portions non-modifiées 152a, 152b de la couche initiale de protection 152 essentiellement sur les flancs de l'empilement de couches qui forment la grille 120. Ces portions non-modifiées 152a, 152b constituent les espaceurs 152a, 152b pour la grille 120 du transistor 200 par exemple de de type FDSOI. De plus, la gravure de la couche de protection modifiée 158 peut être également réalisée pour la réalisation des espaceurs d'un transistor tridimensionnel de type FinFET sans que cette application soit limitative de l'invention.

Des étapes additionnelles peuvent par exemple être des étapes standard où l'on réalise possiblement les extensions des zones source/drain par implantation ionique de dopants avant croissance épitaxiale des source/drain surélevés de transistors FDSOI.

Comme mentionné ci-dessus, le mode de réalisation illustré en figures **4a** à **4g** montre la fabrication des espaceurs 152a, 152b du transistor 200 par exemple de type PMOS, sans consommer la couche 311 comprenant du carbone recouvrant la structure 300 tel qu'un transistor de type NMOS, afin d'empêcher la couche 311 comprenant du carbone d'être endommagée par la réalisation des étapes de modification 430 et de retrait 460 et 470.

Le procédé de l'invention peut être appliqué pour fabriquer des dispositifs microélectroniques sur un même substrat sur lequel aucun des dispositifs en cours de fabrication n'est recouvert et protégé par une couche de protection telle que la couche 311 comprenant du carbone.

Les paragraphes qui suivent donnent des conditions de mise en oeuvre non limitatives des étapes de modes de réalisation du procédé selon l'invention.

Dépôt 410 de la couche de protection 152 destinée à former les espaceurs de grille : l'épaisseur est typiquement comprise dans une gamme allant de 5 à 20 nanomètres (nm) sans cependant que l'invention soit limitée à ces valeurs. Les matériaux susceptibles de convenir incluent le nitrure de silicium (SiN) ainsi que les matériaux dits à « faible k » comprenant l'oxycarbure de silicium (SiCO), le carbure de silicium (SiC), le carbonitrure de silicium (SiCN), et d'autres composés comme le SiOCN et le SiCBN dans une forme poreuse ou non.

Modification 430 par implantation de la couche de protection 152 destinée à former les espaceurs : elle se fait dans tout type de graveur plasma et notamment dans ceux dits ICP, acronyme de l'anglais « inductive coupled plasma » c'est-à-dire « plasma à couplage inductif » pourvus d'un moyen de contrôle de l'énergie des ions. L'épaisseur modifiée est typiquement comprise dans une gamme allant de 1 à quelques dizaines de nanomètres. Les conditions sont typiquement celles du tableau ci-après. Les fenêtres étendues de réglage ci-dessous sont largement dépendantes des applications et des épaisseurs des films. Par exemple, pour modifier du nitrure de silicium sur une épaisseur de 17 nm, les conditions particulières sont : pression (mTorr) = 10 ; bias RF voltage (volt) = 250 ; temps (sec) = 60 ; He = 250 sccm ; CH4 = 10 sccm ; ***TCP RF Power (watts)* = *250V.***

| | |
|---|---|
| Chimie : | He/CH4 ou H2/CH4/Ar |
| Puissance de la source : | 0-2000 Watts |
| H2 : | 10-500 sccm |
| He : | 10-500 sccm |
| Ar : | 100-1000 sccm |
| CH4 : | 5-15 sccm |
| Polarisation (« bias ») : | 20V to 500V |
| Pression : | 5mTorr à 100 mTorr |
| Température : | 10°C to 100°C |
| Temps : | de quelques secondes à quelques centaines de secondes. |

Formation 440 du film protecteur 190 : de préférence dans le même réacteur que pour l'étape 430 ci-dessus (ICP). Le dépôt se fait sur la couche 311 comprenant du carbone, typiquement une résine photosensible et sur le matériau constituant les espaceurs. Les conditions sont typiquement celles du tableau ci-après. Les faibles temps de déposition sont indépendants des applications. Les conditions particulières pour un dépôt de 10 nm d'oxyde sont par exemple : pression (mTorr) = 10 ; bias RF voltage (v) = 0 ; temps (sec) = 10 ; SiCl₄ = 95 sccm ; O2 = 50 sccm ; TCP RF Power (watts) = 100.

| | |
|---|---|
| Conditions : | Gaz contenant du silicium SiCl₄ ou SiF4 et un diluant, par exemple : O2 ou N2. |
| Puissance de la source : | 0-2000 Watts |
| Gaz contenant du Si : | 10-200 sccm |
| Diluant : | 5-500 sccm |
| Polarisation (« bias ») : | 0V à 200 V |
| Pression : | 5mTorr à 100 mTorr |
| Température : | 10°C à 100°C |
| Temps : | quelques secondes |

Retrait 450 du film de protection 190 sur les surfaces parallèles au plan de l'empilement : de préférence dans le même réacteur que ci-dessus pour les étapes 430, 440(ICP). Les conditions sont typiquement celles du tableau ci-après. Le temps de gravure appliqué durant cette étape est directement dépendant de l'étape précédente, par exemple si l'on dépose 15 nm sur la couche 311 à base de carbone, il faudra que le temps de gravure de l'étape 450 soit suffisamment long pour retirer les 15 nm de dépôts.

Les conditions particulières pour un enlèvement d'une épaisseur de 10 nm sont par exemple : pression (mTorr) = 10 ; bias RF voltage (v) = 150 ; temps (sec) = 300 ; Ar = 475 sccm ; TCP RF Power (w) = 100

| | |
|---|---|
| Conditions : | Utilisation d'un gaz neutre. |
| Puissance de la source : | 100-2000 Watts |
| Gaz neutre : | 10-500 sccm |
| Polarisation (« bias ») : | 0V à 600 V |
| Pression : | 5mTorr à 100 mTorr |
| Température : | 10°C to 100°C |
| Temps : | de quelques sec. à quelque centaines de secondes |

Retrait 460 de la couche 311 comprenant du carbone (résine par exemple) : se fait dans tout type de graveur à couplage inductif (ICP) comme ci-dessus ou à couplage capacitif (CCP) ou à plasma délocalisé (remote plasma/downstream). Les conditions sont typiquement celles du tableau ci-après. Les conditions particulières pour un enlèvement d'une épaisseur de 240 nm sont par exemple : pression (mTorr) = 10 ; bias RF voltage (v) = 0 ; temps (sec) = 45 ; O₂ = 200 sccm TCP RF Power (w) = 600

| | |
|---|---|
| Conditions : | Le gaz utilisé par cette opération est déterminé par le type de matériau déposé. On utilise O₂ si le dépôt a été fait à partir de SiCl₄/O₂ ou N₂ si on a utilisé du SiCl₄/N₂. |
| Puissance de la source : | 100-2000 Watts |
| N₂ : | 30-500 sccm |
| H₂ : | 30-500 sccm |
| O₂: | 30-500 sccm |
| Polarisation (« bias ») : | 0V à 850 V |
| Pression : | 5mTorr à 100 mTorr |
| Température : | 10°C to 400°C |
| Temps : | de quelques sec. à quelque centaines de secondes |

Retrait 470 de la couche modifiée 158 du matériau constituant les espaceurs : se fait à l'aide d'une gravure humide. L'épaisseur de la couche modifiée à enlever est typiquement comprise entre 1 et quelques dizaines de nanomètres avec une solution à base d'acide fluorhydrique (HF) diluée par exemple à 1%. Elle peut aussi se faire en employant une solution d'acide phosphorique (H3PO4). Par exemple, pour enlever 10 nm de nitrure de silicium modifié on peut utiliser une solution HF à 1% pendant 30 secondes ou une solution H3PO4 pendant le même temps.

Comme indiqué dans la description détaillée, l'enlèvement de la couche modifiée 158 peut aussi se faire en utilisant un plasma dit ***délocalisé.*** L'épaisseur de la couche modifiée à enlever est ici aussi typiquement comprise entre 1 et quelques dizaines de nanomètres. Les conditions de mise en oeuvre comprennent deux étapes :
- Dans une première étape on génère des sels solides à partir d'une chimie basée soit sur l'utilisation de fluor et d'hydrogène et des produits comme le trifluorure d'azote (NF3) ou l'ammoniac (NH3) et un processus similaire à celui obtenu avec l'acide fluorhydrique (HF), soit sur l'utilisation de phosphine (PH3) combinée avec l'hydrogène et l'oxygène pour un processus similaire à celui de l'acide phosphorique (H3PO4). Les temps nécessaires vont de quelques secondes à quelques minutes, la température de 10°C à 50°C et la pression de quelques mTorr à quelques Torr.
- On procède ensuite à une sublimation des sels produits à une température supérieure à 100°C pendant quelques dizaines de secondes.

Par exemple, pour enlever 10 nm de nitrure de silicium modifié, on peut utiliser du trifluorure d'azote (NF3) avec un débit de 50 sccm, de l'ammoniac avec un débit de 300 sccm à une température de 30°C pendant 45 secondes pour produire les espèces solides qui sont ensuite sublimées à une température de 180°C pendant 60 secondes.

De la description qui précède, il ressort de nombreux avantages conférés par l'invention. Le procédé de l'invention permet notamment une modification anisotrope réalisée de manière très sélective au carbone, aux portions non modifiées de la couche de protection qui constituent des espaceurs pour la grille et à un matériau semi-conducteur tel que le silicium.

Le film carboné 271 formé lors de l'étape de modification du procédé résiste au bombardement des ions du plasma, ce qui permet de protéger la couche de protection 158 lors de l'étape de modification ainsi que lors de l'étape de retrait 470. Par ailleurs, le film protecteur 190 permet de protéger le film carboné 271 et les espaceurs lors de l'étape 460 de retrait de la couche 311 comprenant du carbone.

Les espaceurs d'un premier type de transistors 200 peuvent ainsi être formés de manière précise, sans induire les inconvénients de l'art antérieur, et tout en préservant les structures 300 protégées par un bloc de masquage formé d'une couche 311 comprenant du carbone.

Le procédé de l'invention s'avère particulièrement avantageuse pour former les espaceurs de transistors de type MOSFET ou FinFET.

L'invention n'est pas limitée aux seuls modes et exemples de réalisation décrits ci-dessus, mais s'étend à tous les modes de réalisation entrant dans la portée des revendications.

## Revendications

1. Procédé de formation d'espaceurs (152a, 152b) d'une grille (120) d'un transistor à effet de champ (200), la grille (120) comprenant un sommet et des flancs et étant située au-dessus d'une couche active (146) en un matériau semi-conducteur, **caractérisé en ce qu'**il comprend :
- au moins une étape de formation (410) d'une couche de protection (152) recouvrant la grille (120), la couche de protection (152) étant une couche à base de nitrure (N) et/ou à base de silicium (Si) et/ou à base de carbone (C) qui présente une constante diélectrique égale ou inférieure à 8 ;
- une étape de dépôt (310) d'une couche (311) comprenant du carbone, cette couche (311) comprenant du carbone étant distante dudit transistor (200);
- au moins une étape de modification (430) de la couche de protection (152) par mise en présence de la couche de protection (152) avec un plasma dans lequel on introduit du CxHy où x est la proportion de carbone (C) et y est la proportion d'hydrogène (H) et comprenant des ions plus lourds que l'hydrogène ; les conditions du plasma, en particulier la concentration en CxHy, l'énergie des ions du plasma et la direction principale d'implantation étant choisies de manière à ce que :
∘ le plasma créé un bombardement d'ions à base d'hydrogène (H, H⁺, H₂⁺, H₃⁺ etc.) provenant du CxHy, le bombardement étant anisotrope selon la direction principale d'implantation qui est parallèle aux flancs de la grille (120), de sorte à former une couche de protection modifiée (158) en modifiant des portions de la couche de protection (152) situées sur le sommet de la grille (120) et de part et d'autre de la grille (120) et de sorte à conserver des portions non-modifiées (152a, 152b) de la couche de protection (152) recouvrant les flancs de la grille (120),
∘ des espèces chimiques du plasma contenant du carbone provenant du CxHy forment un film carboné (271) notamment sur les flancs de la grille (120) ;
∘ le plasma créé un bombardement des ions plus lourds que l'hydrogène qui empêche audites espèces chimiques du plasma contenant du carbone et provenant du CxHy de former un film carboné (271) notamment sur les surfaces de la couche de protection (152) qui sont perpendiculaires à la direction (351) principale d'implantation ;
- au moins une étape de formation (440) d'un film protecteur (190) sur au moins la couche (311) comprenant du carbone ainsi que sur la couche de protection modifiée (158) et sur le film carboné (271) recouvrant la grille (120);
- une étape de retrait (450) effectuée de manière à retirer le film protecteur (190) sur les surfaces du film protecteur (190) qui sont perpendiculaires à la direction (351) principale d'implantation et de manière à conserver le film protecteur (190) sur les surfaces du film protecteur (190) qui sont parallèles à la direction (351) principale d'implantation;
- une étape de retrait (460) de la couche (311) comprenant du carbone sélectivement à la couche de protection modifiée (158) et au film protecteur (190) ;
- au moins une étape de retrait (470) de la couche de protection modifiée (158) à l'aide d'une gravure sélective de la couche de protection modifiée (158) vis-à-vis des portions non-modifiées (152a, 152b) de la couche de protection (152).

2. Procédé selon la revendication précédente dans lequel la couche (311) comprenant du carbone est prise parmi : une couche de résine photosensible, une couche de résine thermosensible, un masque dur de préférence formé de carbone.

3. Procédé selon l'une quelconque des deux revendications précédentes dans lequel la couche (311) comprenant du carbone est configurée pour recouvrir une structure (300) distincte dudit transistor (200), et de préférence dans lequel ledit transistor (200) est un transistor NMOS et ladite structure (300) est un transistor PMOS, ou dans lequel ledit transistor (200) est un transistor PMOS et ladite structure (300) est un transistor NMOS.

4. Procédé selon l'une quelconque des revendications précédentes dans lequel l'étape de modification (430) de la couche de protection (152) et l'étape (440) de formation du film protecteur (190) sont effectuées dans un même réacteur plasma.

5. Procédé selon l'une quelconque des revendications précédentes dans lequel l'étape de retrait (450) du film protecteur (190) comprend une gravure effectuée de manière à retirer le film protecteur (190) sur le sommet de la grille (120) et sur au moins un sommet de la couche (311) comprenant du carbone et de manière à conserver le film protecteur (190) sur les flancs de la grille (120).

6. Procédé selon l'une quelconque des revendications précédentes dans lequel le film protecteur (190) située sur les flancs de la grille (120) est retiré lors de l'étape de retrait (470) de la couche de protection modifiée (158) et de préférence dans lequel le film protecteur (190) est pris parmi : un oxyde et un nitrure.

7. Procédé selon la revendication 1 dans lequel la couche de protection (152) présente une constante diélectrique inférieure à 6 et de préférence à 4 et de préférence inférieure à 3.1 et de préférence inférieure ou égale à 2.

8. Procédé selon l'une quelconque des revendications précédentes dans lequel la couche de protection (152) est prise parmi : une couche à base de nitrure (N), une couche de nitrure de silicium (SiN), une couche à base de silicium (Si), une couche à base de carbone (C).

9. Procédé selon l'une quelconque des revendications 1 à 6 dans lequel le matériau de la couche de protection (152) est pris parmi : le SiCO, le SiC, le SiCN, le SiOCN, le SiCBN, le SiOCH, le CBN, le BN, et le SiO2.

10. Procédé selon l'une quelconque des revendications précédentes dans lequel la couche de protection (152) est une couche poreuse.

11. Procédé selon l'une quelconque des revendications 1 à 9 dans lequel l'étape de formation (410) de la couche de protection (152) comprend une étape de dépôt de la couche de protection (152) au cours de laquelle on effectue une étape de réduction de la constante diélectrique de la couche de protection (152) et de préférence dans lequel l'étape de réduction de la constante diélectrique de la couche de protection (152) comprend l'introduction d'une porosité dans la couche de protection (152) et/ou dans lequel l'étape de formation (410) de la couche de protection (152) comprend l'introduction de précurseurs dans la couche de protection (152) en cours de dépôt.

12. Procédé selon l'une quelconque des revendications précédentes dans lequel lors de ladite étape de modification (430) de la couche de protection (152), la concentration en CxHy dans le plasma est comprise entre 2% et 50% et de préférence entre 4% et 40% et/ou la concentration en ions plus lourds que l'hydrogène dans le plasma est comprise entre 50% et 98%.

13. Procédé selon l'une quelconque des revendications précédentes dans lequel les ions plus lourds que l'hydrogène sont pris parmi l'argon (Ar), l'hélium (He), l'azote (N2), le xénon (Xe) et l'oxygène (O2).

14. Procédé selon l'une quelconque des revendications précédentes dans lequel l'étape de modification (430) est réalisée de manière à ce que le plasma génère un bombardement des ions plus lourds que l'hydrogène de manière anisotrope selon la direction principale d'implantation parallèle aux flancs de la grille (120) de sorte à empêcher audites espèces chimiques du plasma contenant du carbone provenant du CxHy de former un film carboné (271) sur les surfaces perpendiculaires aux flancs de la grille (120).

15. Procédé selon l'une quelconque des revendications précédentes dans lequel l'étape de modification (430) est réalisée de manière à ce que les ions plus lourds que l'hydrogène du plasma dissocient la molécule du CxHy de sorte à permettre aux ions hydrogène (H) provenant du CxHy de former des ions à base d'hydrogène et de s'implanter dans lesdites portions (158) de la couche de protection (152).

## Patentansprüche

1. Verfahren zum Bilden von Abstandshaltern (152a, 152b) eines Gates (120) von einem Feldeffekttransistor (200), wobei das Gate (150) einen Scheitelpunkt und Flanken aufweist und oberhalb einer Wirkschicht (146) aus einem Halbleitermaterial liegt, **dadurch gekennzeichnet, dass** es umfasst:
- zumindest einen Schritt (410) des Bildens einer das Gate (120) überdeckenden Schutzschicht (152), wobei die Schutzschicht (152) eine Schicht auf Basis von Nitrid (N) und/oder auf Basis von Silicium (Si) und/oder auf Basis von Kohlenstoff (C) ist, die eine Dielektrizitätskonstante gleich oder kleiner als 8 aufweist;
- einen Schritt (310) des Aufbringens einer kohlenstoffhaltigen Schicht (311), wobei diese kohlenstoffhaltige Schicht (311) vom Transistor (200) beabstandet ist;
- zumindest einen Schritt (430) des Modifizierens der Schutzschicht (152) durch Inkontaktbringen der Schutzschicht (152) mit einem Plasma, in welches CxHy eingebracht wird, worin x der Kohlenstoffanteil (C) und y der Wasserstoffanteil (H) ist, und das schwerere Ionen als Wasserstoff enthält; wobei die Bedingungen des Plasmas, insbesondere die CxHy-Konzentration, die Energie der Ionen des Plasmas und die Implantationshauptrichtung so ausgewählt sind, dass:
• das Plasma eine lonenbombardierung auf Basis von Wasserstoff (H, H⁺, H₂⁺, H₃⁺, etc.) aus dem CxHy schafft, wobei die Bombardierung in der Implantationshauptrichtung anisotrop ist, die parallel zu den Flanken des Gates (120) verläuft, so dass eine modifizierte Schutzschicht (158) gebildet wird, indem die an dem Scheitelpunkt des Gates (120) und beiderseits des Gates (120) liegenden Abschnitte der Schutzschicht (152) modifiziert werden und so dass nicht modifizierte Abschnitte (152a, 152b) der Schutzschicht (152), welche die Flanken des Gates (120) überdeckt, beibehalten werden,
• chemische Spezies des kohlenstoffhalten Plasmas, das aus CxHy stammt, einen kohlenstoffhaltigen Film (271) insbesondere an den Flanken des Gates (120) bilden;
• das Plasma eine Bombardierung mit schwereren Ionen als Wasserstoff schafft, das die chemischen Spezies des kohlenstoffhaltigen und aus CxHy stammenden Plasmas daran hindert, einen kohlenstoffhaltigen Film (271) insbesondere an denjenigen Flächen der Schutzschicht (152) zu bilden, die senkrecht zur Implantationshauptrichtung (351) verlaufen;
- zumindest einen Schritt (440) des Bildens eines Schutzfilms (190) zumindest auf der kohlenstoffhaltigen Schicht (311) sowie auf der modifizierten Schutzschicht (158) und auf dem das Gate (120) überdeckenden kohlenstoffhaltigen Film (271);
- einen Schritt (450) des Entfernens, der so erfolgt, dass der Schutzfilm (190) auf denjenigen Flächen des Schutzfilms (190) entfernt wird, die senkrecht zur Implantationshauptrichtung (351) verlaufen und dass der Schutzfilm (190) auf denjenigen Flächen des Schutzfilms (190) beibehalten wird, die parallel zur Implantationshauptrichtung (351) verlaufen;
- einen Schritt (460) des Entfernens der kohlenstoffhaltigen Schicht (311) selektiv an der modifizierten Schutzschicht (158) und an dem Schutzfilm (190);
- zumindest einen Schritt (470) des Entfernens der modifizierten Schutzschicht (158) mit Hilfe einer selektiven Ätzung der modifizierten Schutzschicht (158) gegenüber von nichtmodifizierten Abschnitten (152a, 152b) der Schutzschicht (152).

2. Verfahren nach dem vorangehenden Anspruch, wobei die kohlenstoffhaltige Schicht (311) ausgewählt ist aus einer lichtempfindlichen Harzschicht, einer wärmeempfindlichen Harzschicht, einer vorzugsweise aus Kohlenstoff gebildeten Hartmaske.

3. Verfahren nach einem der beiden vorangehenden Ansprüche, wobei die kohlenstoffhaltige Schicht (311) dazu ausgelegt ist, eine von dem Transistor (200) separate Struktur (300) zu überdecken und wobei vorzugsweise der Transistor (200) eine NMOS-Transistor ist und die Struktur (300) ein PMOS-Transistor ist, oder wobei der Transistor (200) ein PMOS-Transistor ist und die Struktur (300) ein NMOS-Transistor ist.

4. Verfahren nach einem der vorangehenden Ansprüche, wobei der Schritt (430) des Modifizierens der Schutzsicht (152) und der Schritt (440) des Bildes des Schutzfilms (190) in einem gleichen Plasmareaktor erfolgen.

5. Verfahren nach einem der vorangehenden Ansprüche, wobei der Schritt (450) des Entfernens des Schutzfilms (190) ein Ätzen umfasst, das so erfolgt, dass der Schutzfilm (190) am Scheitelpunkt des Gates (120) und an zumindest einem Scheitelpunkt der kohlenstoffhaltigen Schicht (311) entfernt wird und der Schutzfilm (190) an den Flanken des Gates (120) beibehalten wird.

6. Verfahren nach einem der vorangehenden Ansprüche, wobei der an den Flanken des Gates (120) befindliche Schutzfilm (190) beim Schritt (470) des Entfernens der modifizierten Schutzschicht (158) entfernt wird und wobei vorzugsweise der Schutzfilm (190) ausgewählt ist Oxid und Nitrid.

7. Verfahren nach Anspruch 1, wobei die Schutzschicht (152) eine Dielektrizitätskonstante kleiner als 6 und vorzugsweise als 4 und vorzugsweise kleiner als 3,1 und vorzugsweise kleiner oder gleich 2 aufweist.

8. Verfahren nach einem der vorangehenden Ansprüche, wobei die Schutzschicht (152) ausgewählt ist aus einer Schicht auf Basis von Nitrid (N), einer Schicht aus Siliciumnitrid (SIN), einer Schicht auf Basis von Silicium (Si), einer Schicht auf Basis von Kohlenstoff (C).

9. Verfahren nach einem der Ansprüche 1 bis 6, wobei das Material der Schutzschicht (152) ausgewählt ist aus SiCO, SiC, SiCN, SiOCN, SiCBN, SiOCH, CBN, BN und SiO2.

10. Verfahren nach einem der vorangehenden Ansprüche, wobei die Schutzschicht (152) eine poröse Schicht ist.

11. Verfahren nach einem der Ansprüche 1 bis 9, wobei der Schritt (410) des Bildens der Schutzschicht (152) einen Schritt des Aufbringens der Schutzschicht (152) umfasst, bei dem ein Schritt des Reduzierens der Dielektrizitätskonstante der Schutzschicht (152) erfolgt, und wobei vorzugsweise der Schritt des Reduzierens der Dielektrizitätskonstante der Schutzschicht (152) das Einbringen einer Porosität in die Schutzschicht (152) umfasst und/oder wobei der Schritt (410) des Bildens der Schutzschicht (152) das Einbringen von Vorläufern in die Schutzschicht (152) während des Aufbringens umfasst.

12. Verfahren nach einem der vorangehenden Ansprüche, wobei bei dem Schritt (430) des Modifizierens der Schutzschicht (152) die CxHy-Konzentration in dem Plasma zwischen 2 % und 50 % und vorzugsweise zwischen 4 % und 40 % beträgt und/oder die Konzentration an schwereren Ionen als Wasserstoff in dem Plasma zwischen 50 % und 98 % beträgt.

13. Verfahren nach einem der vorangehenden Ansprüche, wobei die schwereren Ionen als Wasserstoff ausgewählt sind aus Argon (Ar), Helium (He), Stickstoff (N2), Xenon (Xe) und Sauerstoff (O2).

14. Verfahren nach einem der vorangehenden Ansprüche, wobei der Schritt (430) des Modifizierens so erfolgt, dass das Plasma eine Bombardierung mit schwereren Ionen als Wasserstoff in in Implantationshauptrichtung anisotroper Weise schafft, die parallel zu den Flanken des Gates (120) verläuft, so dass es den chemischen Spezies des kohlenstoffhaltigen und aus CxHy stammenden Plasmas daran hindert, einen kohlenstoffhaltigen Film (271) an den senkrecht zu den Flanken des Gates (120) verlaufenden Flächen zu bilden.

15. Verfahren nach einem der vorangehenden Ansprüche, wobei der Schritt (430) des Modifizierens so erfolgt, dass die schwereren Ionen als Wasserstoff des Plasmas das Molekül von CxHy dissoziieren, so dass den Wasserstoff-Ionen (H) aus dem CxHy gestattet wird, Ionen auf Basis von Wasserstoff zu bilden und sich in den Abschnitten (158) der Schutzschicht (152) zu implantieren.

## Claims

1. Method for forming spacers (152a, 152b) of a gate (120) of a field-effect transistor (200), the gate (120) comprising a top and sides and being located above an active layer (146) made of a semiconductor material, **characterised in that** said method comprises:
- at least one step (410) of forming a protective layer (152) covering the gate (120), the protective layer (152) being a layer containing nitride (N) and/or containing silicon (Si) and/or containing carbon (C) that has a dielectric constant less than or equal to 8;
- a step (310) of depositing a layer (311) comprising carbon, this layer (311) comprising carbon being distant from said transistor (200);
- at least one step (430) of modifying the protective layer (152) by placing the protective layer (152) in the presence of a plasma into which CxHy is introduced, where x is the proportion of carbon (C) and y is the proportion of hydrogen (H), and comprising ions heavier than hydrogen; the conditions of the plasma, in particular the concentration of CxHy, the energy of the ions of the plasma, and the main implantation direction being chosen in such a way that:
∘ the plasma creates a bombardment of ions made from hydrogen (H, H⁺, H₂⁺, H₃⁺, etc.) coming from the CxHy, the bombardment being anisotropic in the main implantation direction that is parallel to the sides of the gate (120), in such a way as to form a modified protective layer (158) by modifying portions of the protective layer (152) located on the top of the gate (120) and on either side of the gate (120) and in such a way as to preserve non-modified portions (152a, 152b) of the protective layer (152) covering the sides of the gate (120),
∘ chemical species of the plasma containing carbon coming from the CxHy form a carbon film (271), in particular on the sides of the gate (120);
∘ the plasma creates a bombardment of ions heavier than hydrogen that prevents said chemical species of the plasma containing carbon and coming from the CxHy from forming a carbon film (271), in particular on the surfaces of the protective layer (152) that are perpendicular to the main implantation direction (351);
- at least one step (440) of forming a protective film (190) on at least the layer (311) comprising carbon, as well as on the modified protective layer (158) and on the carbon film (271) covering the gate (120);
- a step (450) of removal carried out in such a way as to remove the protective film (190) on the surfaces of the protective film (190) that are perpendicular to the main implantation direction (351) and in such a way as to preserve the protective film (190) on the surfaces of the protective film (190) that are parallel to the main implantation direction (351);
- a step (460) of removal of the layer (311) comprising carbon selectively with respect to the modified protective layer (158) and the protective film (190);
- at least one step (470) of removal of the modified protective layer (158) using selective etching of the modified protective layer (158) with respect to non-modified portions (152a, 152b) of the protective layer (152).

2. Method according to the preceding claim, wherein the layer (311) comprising carbon is taken from: a layer of photosensitive resin, a layer of heat-sensitive resin, a hard mask preferably formed by carbon.

3. Method according to any one of the two preceding claims, wherein the layer (311) comprising carbon is configured to cover a structure (300) distinct from said transistor (200), and preferably wherein said transistor (200) is an NMOS transistor and said structure (300) is a PMOS transistor, or wherein said transistor (200) is a PMOS transistor and said structure (300) is an NMOS transistor.

4. Method according to any one of the preceding claims, wherein the step (430) of modifying the protective layer (152) and the step (440) of forming the protective film (190) are carried out in the same plasma reactor.

5. Method according to any one of the preceding claims, wherein the step (450) of removal of the protective film (190) comprises etching carried out in such a way as to remove the protective film (190) on the top of the gate (120) and on at least one top of the layer (311) comprising carbon and in such a way as to preserve the protective film (190) on the sides of the gate (120).

6. Method according to any one of the preceding claims, wherein the protective film (190) located on the sides of the gate (120) is removed during the step (470) of removal of the modified protective layer (158), and preferably wherein the protective film (190) is taken from: an oxide and a nitride.

7. Method according to claim 1, wherein the protective layer (152) has a dielectric constant less than 6 and preferably less than 4 and preferably less than 3.1 and preferably less than or equal to 2.

8. Method according to any one of the preceding claims, wherein the protective layer (152) is taken from: a layer containing nitride (N), a layer of silicon nitride (SiN), a layer containing silicon (Si), a layer containing carbon (C).

9. Method according to any one of the claims 1 to 6, wherein the material of the protective layer (152) is taken from: SiCO, SiC, SiCN, SiOCN, SiCBN, SiOCH, CBN, BN, and SiO2.

10. Method according to any one of the preceding claims, wherein the protective layer (152) is a porous layer.

11. Method according to any one of the claims 1 to 9, wherein the step (410) of forming the protective layer (152) comprises a step of deposition of the protective layer (152) during which a step of reducing the dielectric constant of the protective layer (152) is carried out, and preferably wherein the step of reducing the dielectric constant of the protective layer (152) involves the introduction of porosity into the protective layer (152) and/or wherein the step (410) of forming the protective layer (152) comprises the introduction of precursors into the protective layer (152) being deposited.

12. Method according to claim 1, wherein during said step (430) of modifying the protective layer (152), the concentration of CxHy in the plasma is between 2% and 50% and preferably between 4% and 40% and/or the concentration of ions heavier than hydrogen in the plasma is between 50% and 98%.

13. Method according to any one of the preceding claims, wherein the ions heavier than hydrogen are taken from argon (Ar), helium (He), nitrogen (N2), xenon (Xe) and oxygen (O2).

14. Method according to any one of the preceding claims, wherein the modification step (430) is carried out in such a way that the plasma generates a bombardment of the ions heavier than hydrogen in an anisotropic manner in the main implantation direction parallel to the sides of the gate (120) in such a way as to prevent said chemical species of the plasma containing carbon coming from the CxHy from forming a carbon film (271) on the surfaces perpendicular to the sides of the gate (120).

15. Method according to any one of the preceding claims, wherein the modification step (430) is carried out in such a way that the ions heavier than hydrogen of the plasma dissociate the molecule of the CxHy in order to allow the hydrogen ions (H) coming from the CxHy to form ions made from hydrogen and be implanted in said portions (158) of the protective layer (152).
